# EUROPEAN PATENT APPLICATION

(11) **EP 2 377 975 A1**
(43) Date of publication of application: **19.10.2011**
(21) Application number: 09830333.2
(22) Date of filing: 26.11.2009
(51) Int. Cl.: C30B 29/38, C23C 16/04, C23C 16/34, H01L 21/205

(54) **METHOD OF GROWING GALLIUM NITRIDE CRYSTALS AND PROCESS FOR PRODUCING GALLIUM NITRIDE CRYSTALS**

(30) Priority: 02.12.2008 JP 2008307624; 02.12.2008 JP 2008307625; 02.12.2008 JP 2008307626
(71) Applicant: Sumitomo Electric Industries, Ltd., Chuo-ku Osaka-shi Osaka 541-0041 (JP)
(72) Inventor: TAKEYAMA, Tomoharu, Itami-shi Hyogo 664-0016 (JP)
(74) Representative: Grünecker, Kinkeldey, Stockmair & Schwanhäusser
(86) International application number: PCT/JP2009/069924
(87) International publication number: WO 2010/064566

(57) **Abstract**

In a method of growing GaN crystal in one aspect, the following steps are performed. An underlying substrate is prepared (step S1). Then, a mask layer having an opening portion and composed of SiO₂ is formed on the underlying substrate (step S2). Then, GaN crystal is grown on the underlying substrate and the mask layer (step S5). The mask layer has surface roughness Rms not greater than 2 nm or a radius of curvature not smaller than 8 m. In a method of growing GaN crystal in one aspect, the following steps are performed. An underlying substrate is prepared (step S1). Then, using a resist, a mask layer having an opening portion is formed on the underlying substrate (step S2). Then, the underlying substrate and the mask layer are cleaned with an acid solution (step S3). Then, after step S3 of cleaning with an acid solution, the underlying substrate and the mask layer are cleaned with an organic solvent (step S4). Then, GaN crystal is grown on the underlying substrate and the mask layer (step S5).

## Description

### TECHNICAL FIELD

The present invention relates to a method of growing gallium nitride crystal and a method of manufacturing gallium nitride crystal.

### BACKGROUND ART

A gallium nitride (GaN) substrate having an energy band gap of 3.4 eV and high thermal conductivity has attracted attention as a material for a semiconductor device such as a short-wavelength optical device or a power electronic device. A method of manufacturing such a GaN substrate is disclosed in Japanese Patent Laying-Open No. 2004-304203 (Patent Document 1) and the like. Patent Document 1 discloses a method of manufacturing a nitride semiconductor substrate with the following method.

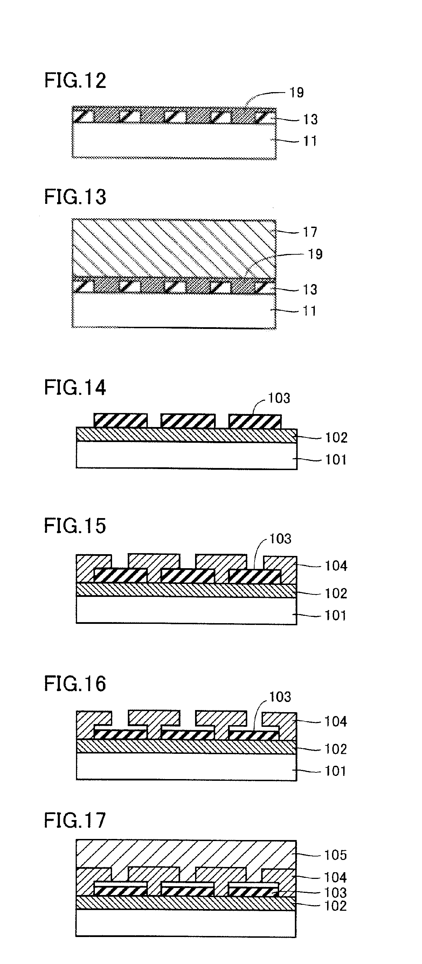

Figs. 14 to 17 are cross-sectional views schematically showing a process for manufacturing a GaN substrate in Patent Document 1 above. As shown in Fig. 14, initially, a nitride semiconductor 102 is grown on a hetero substrate 101. Then, a protection film 103 is formed and a resist is further applied. Then, etching with photolithography to form a prescribed shape is performed such that protection film 103 composed of silicon dioxide (SiO₂) or the like has a window portion. Then, as shown in Fig. 15, when a first nitride semiconductor 104 is grown in the window portion in protection film 103 with nitride semiconductor 102 serving as a nucleus and first nitride semiconductor 104 grows in a lateral direction over protection film 103, growth of first nitride semiconductor 104 is stopped before it completely covers protection film 103. Then, as shown in Fig. 16, protection film 103 for first nitride semiconductor 104 is removed. Then, as shown in Fig. 17, a second nitride semiconductor 105 is grown on first nitride semiconductor 104 from which protection film 103 was removed, over an upper surface and a side surface of first nitride semiconductor 104.

### PRIOR ART DOCUMENTS

### PATENT DOCUMENTS

Patent Document 1: Japanese Patent Laying-Open No. 2004-304203

### SUMMARY OF THE INVENTION

### PROBLEMS TO BE SOLVED BY THE INVENTION

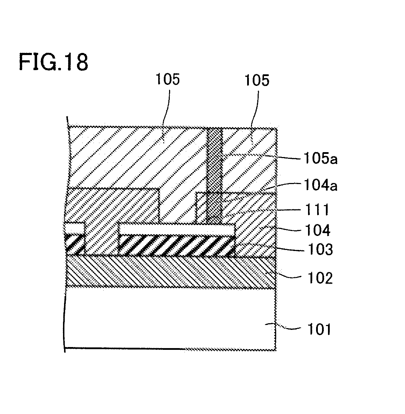

Fig. 18 is an enlarged view of a substantial portion in Fig. 17. The present inventor found that a polycrystalline nucleus 111 is generated above protection film 103 in Patent Document 1 above, as shown in Fig. 18. In addition, the present inventor found the problem that, when polycrystalline nucleus 111 is generated, polycrystalline first and second nitride semiconductors 104a and 105a are grown on this nucleus 111.

Therefore, the present invention provides a method of growing GaN crystal and a method of manufacturing GaN crystal, capable of suppressing growth of polycrystalline GaN crystal.

### MEANS FOR SOLVING THE PROBLEMS

As a result of dedicated studies of a factor for growth of polycrystalline GaN crystal in Patent Document 1 above, the present inventor found that atoms at a surface of protection film 103 formed in Patent Document 1 above have more bonds not bonded to another atom (dangling bonds) than atoms inside thereof Therefore, when first nitride semiconductor 104 is grown as shown in Fig. 15, atoms in first nitride semiconductor 104 are more likely to be taken into atoms at the surface of protection film 103. When atoms in first nitride semiconductor 104 are taken into atoms at the surface of protection film 103, polycrystalline nucleus 111 is generated above protection film 103 as shown in Fig. 18. Polycrystalline first nitride semiconductor 104a grows on this polycrystalline nucleus 111, and polycrystalline second nitride semiconductor 105a grows thereon.

Consequently, the present inventor found that, in a method of growing GaN crystal with the use of a mask layer (protection film), quality of grown GaN crystal is affected by a property of the mask layer. Then, as a result of dedicated studies of a condition for a mask layer for suppressing growth of polycrystalline GaN crystal, the present inventor found the present invention.

Namely, in a method of growing GaN crystal in one aspect of the present invention, the following steps are performed. Initially, an underlying substrate is prepared. Then, a mask layer having an opening portion and composed of SiO₂ is formed on the underlying substrate. Then, GaN crystal is grown on the underlying substrate and the mask layer. The mask layer has surface roughness Rms not greater than 2 nm.

According to the method of growing GaN crystal in one aspect of the present invention, a surface area of the mask layer can be made smaller by setting surface roughness Rms of the mask layer to 2 nm or smaller. Therefore, the number of atoms present at the surface can be decreased. Atoms present at the surface of the mask layer have excess bonds as compared with atoms present inside. Therefore, the number of atoms having excess bonds, that are present at the surface of the mask layer, can be decreased. Thus, at least one of Ga atom and N atom reacting to a bond of at least one of Si atom and O atom and bonding thereto with growth of GaN crystal on this mask layer can be suppressed. Consequently, since formation of a GaN polycrystalline nucleus on the mask layer can be suppressed, growth of polycrystalline GaN crystal can be suppressed.

In the method of growing GaN crystal in one aspect above, preferably, the mask layer has surface roughness Rms not greater than 0.5 nm.

Thus, the number of atoms having excess bonds, that are present at the surface of the mask layer, can effectively be decreased. Therefore, growth of polycrystalline GaN crystal can further be suppressed.

In the method of growing GaN crystal in one aspect above, preferably, the mask layer has a radius of curvature not smaller than 8 m.

If strain energy is generated in the mask layer, at least one of Si atom and O atom is bonded to at least one of Ga atom and N atom, in order to mitigate this strain energy. The present inventor, however, found that warp of the surface of the mask layer can be lessened by setting a radius of curvature of the mask layer to 8 m or greater. Thus, strain energy in the mask layer can be lowered. Therefore, at least one of Si atom and O atom in the mask layer reacting to at least one of Ga atom and N atom and bonding thereto with growth of GaN crystal can be suppressed. Therefore, formation of a GaN polycrystalline nucleus on the mask layer can be suppressed. Thus, growth of polycrystalline GaN crystal can further be suppressed.

In the method of growing GaN crystal in one aspect above, preferably, the mask layer has a radius of curvature not smaller than 50 m.

Thus, strain energy in the mask layer can effectively be lowered. Therefore, growth of polycrystalline GaN crystal can further be suppressed.

In the method of growing GaN crystal in one aspect above, preferably, the following steps are performed between the step of forming a mask layer above and the step of growing GaN crystal above. A buffer layer composed of GaN is formed on the underlying substrate. Then, the buffer layer is subjected to heat treatment at a temperature not lower than 800°C and not higher than 1100°C.

Matching of a lattice constant between the underlying substrate and GaN crystal can be relaxed by forming a buffer layer. In addition, by subjecting the buffer layer to heat treatment at the temperature above, crystal in the buffer layer can be changed from amorphous to monocrystalline. Therefore, crystallinity of the GaN crystal can be improved.

In the method of growing GaN crystal in one aspect above, preferably, the following steps are performed between the step of forming a mask layer above and the step of forming a buffer layer above. The underlying substrate and the mask layer are cleaned with an acid solution. After the step of cleaning with an acid solution, the underlying substrate and the mask layer are cleaned with an organic solvent.

In addition, in the method of growing GaN crystal in one aspect above, preferably, the following steps are performed between the step of forming a mask layer above and the step of growing GaN crystal above. The underlying substrate and the mask layer are cleaned with an acid solution. After the step of cleaning with an acid solution, the underlying substrate and the mask layer are cleaned with an organic solvent.

In the step of forming a mask layer above, a resist is normally used for forming a mask layer having an opening portion. Therefore, after the mask layer is formed, a reaction product or the like derived from the resist may remain on the underlying substrate and the mask layer. By cleaning with an acid solution, the reaction product remaining on the underlying substrate and the mask layer can be decomposed into a hydrophilic portion and a lipophilic portion and the hydrophilic portion can be dissolved. Consequently, the hydrophilic portion of the reaction product can be removed. Since the lipophilic portion in the reaction product that could not be removed with the acid solution has good affinity for a lipophilic organic solvent, the lipophilic portion of the reaction product can be removed by cleaning with an organic solvent. Therefore, since the reaction product remaining on the underlying substrate and the mask layer can be removed separately as divided into the hydrophilic portion and the lipophilic portion, the reaction product can be removed at the atomic level. Therefore, growth of polycrystalline GaN with this reaction product serving as a nucleus can further be suppressed.

In the method of growing GaN crystal in one aspect above, preferably, in the step of cleaning with an acid solution above and the step of cleaning with an organic solvent above, ultrasound is applied to the acid solution and the organic solvent.

Thus, since fine particles adhering to the surface of the underlying substrate and the mask layer can be removed, generation of a polycrystalline nucleus can further be suppressed.

A method of manufacturing GaN crystal in one aspect of the present invention includes the steps of growing GaN crystal with the method of growing GaN crystal described in any paragraph above and removing the underlying substrate and the mask layer.

According to the method of manufacturing GaN crystal in one aspect of the present invention, since the method of growing GaN crystal above is employed, grown GaN crystal is prevented from becoming polycrystalline. Therefore, by removing at least the underlying substrate and the mask layer, GaN crystal prevented from becoming polycrystalline can be manufactured.

In addition, as a result of dedicated studies, the present inventor found that the problem of growth of polycrystalline GaN crystal in Patent Document 1 above originates from generation of strain energy in protection film 103 formed in Patent Document 1 above. When strain energy is generated in protection film 103, in order to mitigate this strain energy, atoms forming protection film 103 are bonded to at least one of Ga atom and N atom. Therefore, as shown in Fig. 15, when first nitride semiconductor 104 is grown, atoms in first nitride semiconductor 104 are more likely to be taken into atoms at the surface of protection film 103. As atoms in first nitride semiconductor 104 are taken into atoms at the surface of protection film 103, polycrystalline nucleus 111 is generated above protection film 103 as shown in Fig. 18. Polycrystalline first nitride semiconductor 104a grows on this polycrystalline nucleus 111, and polycrystalline second nitride semiconductor 105a grows thereon.

Consequently, the present inventor found that, in a method of growing GaN crystal with the use of a mask layer (protection film), quality of grown GaN crystal is affected by a property of the mask layer. Then, as a result of dedicated studies of a condition for a mask layer for suppressing growth of polycrystalline GaN crystal, the present inventor found the present invention.

Namely, in a method of growing GaN crystal in one aspect of the present invention, the following steps are performed. Initially, an underlying substrate is prepared. Then, a mask layer having an opening portion and composed of silicon dioxide is formed on the underlying substrate. Then, GaN crystal is grown on the underlying substrate and the mask layer. The mask layer has a radius of curvature not smaller than 8 m.

According to the method of growing GaN crystal in one aspect of the present invention, warp of the surface of the mask layer can be lessened by setting a radius of curvature of the mask layer to 8 m or greater. Thus, strain energy in the mask layer can be lowered. Thus, at least one of Si atom and O atom in the mask layer reacting to at least one of Ga atom and N atom and bonding thereto with growth of GaN crystal can be suppressed. Therefore, formation of a GaN polycrystalline nucleus on the mask layer can be suppressed. Thus, growth of polycrystalline GaN crystal can be suppressed.

In the method of growing GaN crystal in one aspect above, preferably, the mask layer has a radius of curvature not smaller than 50 m.

Thus, strain energy in the mask layer can effectively be lowered. Therefore, growth of polycrystalline GaN crystal can further be suppressed.

In the method of growing GaN crystal in one aspect above, preferably, the following steps are performed between the step of forming a mask layer above and the step of growing GaN crystal above. A buffer layer composed of GaN is formed on the underlying substrate. Then, the buffer layer is subjected to heat treatment at a temperature not lower than 800°C and not higher than 1100°C.

Matching of a lattice constant between the underlying substrate and GaN crystal can be relaxed by forming a buffer layer. In addition, by subjecting the buffer layer to heat treatment at the temperature above, crystal in the buffer layer can be changed from amorphous to monocrystalline. Therefore, crystallinity of the GaN crystal can be improved.

In the method of growing GaN crystal in one aspect above, preferably, the following steps are performed between the step of forming a mask layer above and the step of forming a buffer layer above. The underlying substrate and the mask layer are cleaned with an acid solution. After the step of cleaning with an acid solution, the underlying substrate and the mask layer are cleaned with an organic solvent.

In addition, in the method of growing GaN crystal in one aspect above, preferably, the following steps are performed between the step of forming a mask layer above and the step of growing GaN crystal above. The underlying substrate and the mask layer are cleaned with an acid solution. After the step of cleaning with an acid solution, the underlying substrate and the mask layer are cleaned with an organic solvent.

In the step of forming a mask layer above, a resist is normally used for forming a mask layer having an opening portion. Therefore, after the mask layer is formed, a reaction product or the like derived from the resist may remain on the underlying substrate and the mask layer. By cleaning with an acid solution, the reaction product remaining on the underlying substrate and the mask layer can be decomposed into a hydrophilic portion and a lipophilic portion and the hydrophilic portion can be dissolved. Consequently, the hydrophilic portion of the reaction product can be removed. Since the lipophilic portion in the reaction product that could not be removed with the acid solution has good affinity for a lipophilic organic solvent, the lipophilic portion of the reaction product can be removed by cleaning with an organic solvent. Therefore, since the reaction product remaining on the underlying substrate and the mask layer can be removed separately as divided into the hydrophilic portion and the lipophilic portion, the reaction product can be removed at the atomic level. Therefore, growth of polycrystalline GaN with this reaction product serving as a nucleus can further be suppressed.

In the method of growing GaN crystal in one aspect above, preferably, in the step of cleaning with an acid solution above and the step of cleaning with an organic solvent above, ultrasound is applied to the acid solution and the organic solvent.

Thus, since fine particles adhering to the surface of the underlying substrate and the mask layer can be removed, generation of a polycrystalline nucleus can further be suppressed.

A method of manufacturing GaN crystal in one aspect of the present invention includes the steps of growing GaN crystal with the method of growing GaN crystal described in any paragraph above and removing the underlying substrate and the mask layer.

According to the method of manufacturing GaN crystal in one aspect of the present invention, since the method of growing GaN crystal above is employed, grown GaN crystal is prevented from becoming polycrystalline. Therefore, by removing at least the underlying substrate and the mask layer, GaN crystal prevented from becoming polycrystalline can be manufactured.

In addition, as a result of dedicated studies, the present inventor found that the problem of growth of polycrystalline GaN crystal in Patent Document 1 above originates from a reaction product derived from a resist used in forming protection film 103. In other words, the present inventor found that a reaction product or the like derived from the resist remaining on the underlying substrate and the mask layer (protection film) results in polycrystalline nucleus 111. Namely, the present inventor found that, in a method of growing GaN crystal with the use of a mask layer, formation of the mask layer affects quality of grown GaN crystal. Then, as a result of dedicated studies of a condition for forming a mask layer for suppressing growth of polycrystalline GaN crystal, the present inventor found the present invention.

Namely, in a method of growing GaN crystal in one aspect of the present invention, the following steps are performed. Initially, an underlying substrate is prepared. Then, a mask layer having an opening portion is formed on the underlying substrate by using a resist. Then, the underlying substrate and the mask layer are cleaned with an acid solution. Then, after the step of cleaning with an acid solution, the underlying substrate and the mask layer are cleaned with an organic solvent. Then, GaN crystal is grown on the underlying substrate and the mask layer.

According to the method of growing GaN crystal in one aspect of the present invention, by cleaning with an acid solution, a reaction product remaining on the underlying substrate and the mask layer can be decomposed into a hydrophilic portion and a lipophilic portion and the hydrophilic portion can be dissolved. Consequently, the hydrophilic portion of the reaction product can be removed. Since the lipophilic portion in the reaction product that could not be removed with the acid solution has good affinity for a lipophilic organic solvent, the lipophilic portion of the reaction product can be removed by cleaning with an organic solvent. Therefore, since the reaction product remaining on the underlying substrate and the mask layer can be removed separately as divided into the hydrophilic portion and the lipophilic portion, the reaction product can be removed at the atomic level. Therefore, growth of polycrystalline GaN with this reaction product serving as a nucleus can be suppressed.

In the method of growing GaN crystal in one aspect above, preferably, in the step of cleaning with an acid solution above and the step of cleaning with an organic solvent above, ultrasound is applied to the acid solution and the organic solvent.

Thus, since fine particles adhering to the surface of the underlying substrate and the mask layer can be removed, generation of a polycrystalline nucleus can further be suppressed.

In the method of growing GaN crystal in one aspect above, preferably, the mask layer is composed of silicon dioxide. Thus, growth of GaN crystal in which generation of a polycrystalline nucleus is effectively suppressed can be realized.

In the method of growing GaN crystal in one aspect above, preferably, the following steps are performed between the step of cleaning with an organic solvent above and the step of growing GaN crystal above. A buffer layer composed of GaN is formed on the underlying substrate. Then, the buffer layer is subjected to heat treatment at a temperature not lower than 800°C and not higher than 1100°C.

Matching of a lattice constant between the underlying substrate and GaN crystal can be relaxed by forming a buffer layer. In addition, by subjecting the buffer layer to heat treatment at the temperature above, crystal in the buffer layer can be changed from amorphous to monocrystalline. Therefore, crystallinity of the GaN crystal can be improved.

A method of manufacturing GaN crystal in one aspect of the present invention includes the steps of growing GaN crystal with the method of growing GaN crystal described in any paragraph above and removing the underlying substrate and the mask layer.

According to the method of manufacturing GaN crystal in one aspect of the present invention, since the method of growing GaN crystal above is employed, grown GaN crystal is prevented from becoming polycrystalline. Therefore, by removing at least the underlying substrate and the mask layer, GaN crystal prevented from becoming polycrystalline can be manufactured.

### EFFECTS OF THE INVENTION

According to the method of growing GaN crystal and the method of manufacturing GaN crystal in the present invention, growth of polycrystalline GaN crystal can be suppressed.

### BRIEF DESCRIPTION OF THE DRAWINGS

Fig. 1 is a schematic cross-sectional view showing GaN crystal in Embodiments 1X to 1Z of the present invention.
Fig. 2 is a flowchart showing a method of manufacturing a GaN substrate in Embodiments 1X to 1Z of the present invention.
Fig. 3 is a cross-sectional view schematically showing an underlying substrate in Embodiments 1X to 1Z of the present invention.
Fig. 4 is a cross-sectional view for illustrating a method of forming a mask layer in Embodiments 1X to 1Z of the present invention.
Fig. 5 is a cross-sectional view schematically showing a state where the mask layer was formed in Embodiments 1X to 1Z of the present invention.
Fig. 6 is a schematic diagram for illustrating a radius of curvature of the mask layer in Embodiments 1X to 1Z of the present invention.
Fig. 7 is a cross-sectional schematic diagram showing a treatment apparatus used in the step of cleaning with an acid solution and the step of cleaning with an organic solvent in Embodiments 1X to 1Z of the present invention.
Fig. 8 is a cross-sectional view schematically showing a state where GaN crystal was grown in Embodiments 1X to 1Z of the present invention.
Fig. 9 is a flowchart showing a method of manufacturing GaN crystal in Embodiments 2X to 2Z of the present invention.
Fig. 10 is a schematic cross-sectional view showing a state where a buffer layer was formed in Embodiments 2X to 2Z of the present invention.
Fig. 11 is a schematic cross-sectional view showing a state where a GaN layer was grown in Embodiments 2X to 2Z of the present invention.
Fig. 12 is a schematic cross-sectional view showing a state where a buffer layer was formed in Embodiments 3X to 3Z of the present invention.
Fig. 13 is a schematic cross-sectional view showing a state where a GaN layer was grown in Embodiments 3X to 3Z of the present invention.
Fig. 14 is a cross-sectional view schematically showing a process for manufacturing a GaN substrate in Patent Document 1 above.
Fig. 15 is a cross-sectional view schematically showing the process for manufacturing a GaN substrate in Patent Document 1 above.
Fig. 16 is a cross-sectional view schematically showing the process for manufacturing a GaN substrate in Patent Document 1 above.
Fig. 17 is a cross-sectional view schematically showing the process for manufacturing a GaN substrate in Patent Document 1 above.
Fig. 18 is an enlarged view of a substantial portion in Fig. 17.

### MODES FOR CARRYING OUT THE INVENTION

An embodiment of the present invention will be described hereinafter with reference to the drawings.

### (Embodiment 1X)

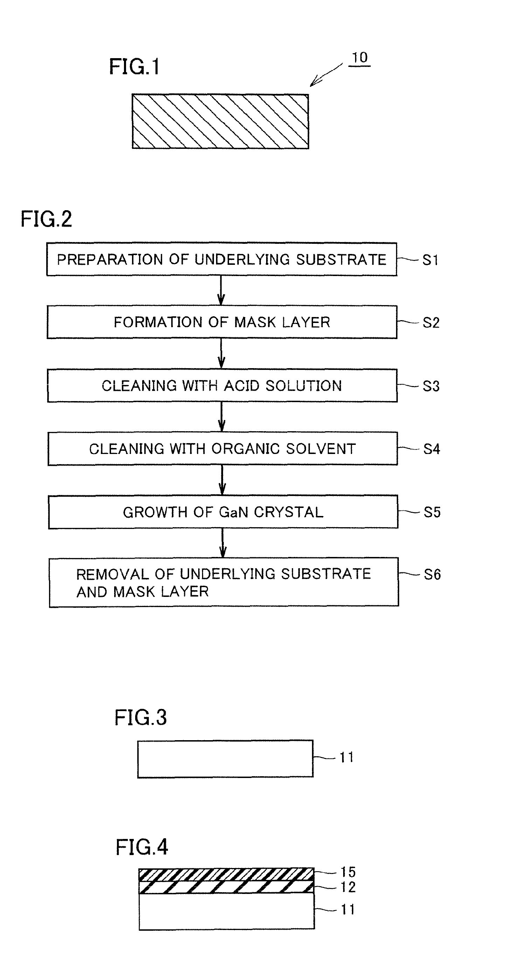

Fig. 1 is a schematic cross-sectional view showing GaN crystal in the present embodiment. GaN crystal in the present embodiment will be described with reference to Fig. 1.

As shown in Fig. 1, GaN crystal 10 in the present embodiment has a main surface and a back surface opposite to this main surface. GaN crystal 10 is implemented, for example, as a substrate or an ingot.

In GaN crystal 10, an area composed of polycrystal is suppressed. For example, an area composed of polycrystal is not higher than 20 % and preferably not higher than 5 %. In addition, GaN crystal 10 has a radius of curvature preferably not smaller than 40 m and further preferably not smaller than 50 m.

Fig. 2 is a flowchart showing a method of manufacturing GaN crystal in the present embodiment. In succession, a method of manufacturing GaN crystal 10 in the present embodiment will be described with reference to Fig. 2.

Fig. 3 is a cross-sectional view schematically showing an underlying substrate 11 in the present embodiment. As shown in Figs. 2 and 3, initially, underlying substrate 11 is prepared (step S1). Prepared underlying substrate 11 may be made of GaN or of a material different from GaN. For a hetero substrate made of a material different from GaN, for example, gallium arsenide (GaAs), sapphire (Al₂O₃), zinc oxide (ZnO), silicon carbide (SiC), or the like can be employed.

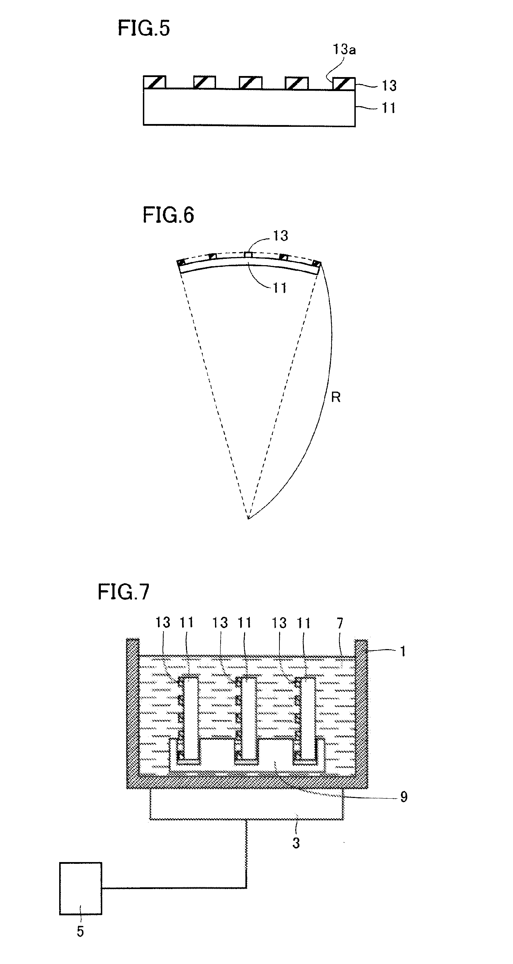

Fig. 4 is a cross-sectional view for illustrating a method of forming a mask layer 13 in the present embodiment. Fig. 5 is a cross-sectional view schematically showing a state where mask layer 13 was formed in the present embodiment. Then, as shown in Figs. 2, 4 and 5, mask layer 13 having an opening portion 13a and composed of SiO₂ is formed on the surface of underlying substrate 11 (step S2).

Step S2 of forming this mask layer 13 is performed, for example, in the following manner. As shown in Fig. 4, initially, an SiO₂ layer 12 serving as a material for mask layer 13 is formed, for example, with a vapor deposition method. Then, a resist 15 is formed on SiO₂ layer 12, for example, by using a coater. Then, a mask pattern is transferred to resist 15, for example, by using a stepper. Any shape such as stripes or dots can be adopted as this mask pattern. Then, a transferred portion of resist 15 is dissolved, to thereby form resist 15 having a pattern. Then, using this resist having a pattern as a mask, SiO₂ layer 12 not covered with resist 15 is etched. Opening portion 13a can thus be formed. Thereafter, resist 15 is removed. A removal method is not particularly limited, and for example, ashing or the like can be employed. Thus, as shown in Fig. 5, mask layer 13 having opening portion 13a can be formed.

Mask layer 13 has surface roughness Rms not greater than 2 nm, preferably not greater than 0.5 nm, and further preferably not greater than 0.2 nm. When the surface roughness is not greater than 2 nm, the number of atoms having excess bonds, that are present at the surface, can be decreased. In this case, generation of a polycrystalline nucleus as a result of reaction between at least one of Si atom and O atom and at least one of Ga atom and N atom supplied in step S5 of growing GaN crystal which will be described later can be suppressed. When the surface roughness is not greater than 0.5 nm, generation of a polycrystalline nucleus can further be suppressed. When the surface roughness is not greater than 0.2 nm, generation of a polycrystalline nucleus can still further be suppressed.

Here, "surface roughness Rms" above is a value measured in conformity with JIS B0601, with the use of an atomic force microscope (AFM), for example, in a field of view of at most 50-µm square in mask layer 13 located substantially in the center. In addition, surface roughness of a sample is preferably measured at five or more points at a pitch not greater than 10 µm in the field of view of at most 50-µm square. In this case, a value of a square root of a value calculated by averaging squares of deviation from a mean line to a traced profile in a roughness profile of this sample is defined as surface roughness Rms. In addition, in a case where it is difficult to measure surface roughness Rms depending on a size and a pitch of opening portion 13a or the like, for example, surface roughness Rms of SiO₂ layer 12 at the time when SiO₂ layer 12 serving as a material for mask layer 13 is formed can be measured and it can also be adopted as surface roughness Rms of mask layer 13.

Fig. 6 is a schematic diagram for illustrating a radius of curvature of mask layer 13 in the present embodiment. As shown in Fig. 6, mask layer 13 has a radius of curvature R preferably not smaller than 8 m and further preferably not smaller than 50 m. When the radius of curvature is not smaller than 8 m, strain energy in mask layer 13 can be suppressed, and hence reaction between at least one of Si atom and O atom in mask layer 13 and at least one of Ga atom and N atom supplied in step S5 of growing GaN crystal which will be described later can be suppressed. Consequently, generation of a polycrystalline nucleus can be suppressed. When the radius of curvature is not smaller than 50 m, generation of a polycrystalline nucleus can further be suppressed.

Here, "radius of curvature R" above means a radius R when it is assumed that a curve along a surface of mask layer 13 grown on underlying substrate 11 draws an arc, for example, as shown in Fig. 6. Regarding such a radius of curvature R, for example, a radius of curvature of SiO₂ layer 12 at the time when SiO₂ layer 12 serving as a material for mask layer 13 is formed is measured and this radius of curvature can also be adopted as the radius of curvature of mask layer 13.

Then, underlying substrate 11 and mask layer 13 are cleaned with an acid solution (step S3). For example, sulfuric acid, hydrofluoric acid, hydrochloric acid, or the like can be employed as the acid solution.

Since resist 15 is used as described above in step S2 of forming a mask layer, a reaction product or the like derived from the resist may remain on mask layer 13. Therefore, by cleaning with an acid solution, the reaction product remaining on underlying substrate 11 and mask layer 13 can be decomposed into a hydrophilic portion having, for example, OH group or the like and a lipophilic portion having, for example, alkyl group or the like, and the hydrophilic portion can be dissolved. Therefore, the hydrophilic portion of the reaction product can be removed.

Then, underlying substrate 11 and mask layer 13 are cleaned with an organic solvent (step S4). For example, acetone, ethanol or the like can be employed as the organic solvent.

After step S3 of cleaning with an acid solution, the lipophilic portion of the reaction product may remain. This lipophilic portion has good affinity for (is likely to blend with) an organic solvent. Therefore, by cleaning with an organic solvent, the lipophilic portion of the reaction product remaining on underlying substrate 11 and mask layer 13 can be removed.

In step S3 of cleaning with an acid solution and step S4 of cleaning with an organic solvent, the reaction product remaining on underlying substrate 11 and mask layer 13 is removed separately as divided into the hydrophilic portion and the lipophilic portion. Therefore, the reaction product derived from the resist can be removed at the atomic level.

In step S3 of cleaning with an acid solution and step S4 of cleaning with an organic solvent, ultrasound is preferably applied to the acid solution and the organic solvent. Specifically, vibration (or shaking) is applied to the acid solution and the organic solvent representing a cleaning liquid, for example, with the use of an ultrasonic apparatus as shown in Fig. 7. It is noted that Fig. 7 is a cross-sectional schematic diagram showing a treatment apparatus used in step S3 of cleaning with an acid solution and step S4 of cleaning with an organic solvent in the present embodiment. Use of ultrasound at a frequency from 900 to 2000 kHz as ultrasound is further effective.

As shown in Fig. 7, a treatment apparatus includes a cleaning bath 1 for holding a cleaning liquid 7 which is an acid solution or an organic solvent, an ultrasound generation member 3 installed on a bottom surface of cleaning bath 1, and a control unit 5 connected to ultrasound generation member 3, for controlling ultrasound generation member 3. Cleaning bath 1 holds cleaning liquid 7 therein. In addition, in cleaning liquid 7, a holder 9 for holding a plurality of underlying substrates 11 each having mask layer 13 formed is immersed. Holder 9 holds a plurality of underlying substrates 11 to be cleaned, each having mask layer 13 formed. Ultrasound generation member 3 is arranged on the bottom surface of cleaning bath 1.

In cleaning underlying substrate 11 having mask layer 13 formed in step S3 of cleaning with an acid solution and step S4 of cleaning with an organic solvent, prescribed cleaning liquid 7 is arranged in cleaning bath 1 as shown in Fig. 7 and underlying substrate 11 having mask layer 13 formed, that is held by holder 9, is immersed in cleaning liquid 7, for each holder 9. Thus, the surface of mask layer 13 and underlying substrate 11 can be cleaned with cleaning liquid 7.

In addition, here, ultrasound may be generated under the control by control unit 5 of ultrasound generation member 3. Consequently, ultrasound is applied to cleaning liquid 7. Therefore, as cleaning liquid 7 vibrates, an effect of removing an impurity or fine particles from mask layer 13 and underlying substrate 11 can be enhanced. In addition, by arranging cleaning bath 1 on a member that can be shaken such as an XY stage and by shaking the member, cleaning bath 1 may be shaken to stir (shake) cleaning liquid 7 therein. Alternatively, by shaking underlying substrate 11 having mask layer 13 formed together with holder 9 with a manual operation or the like, cleaning liquid 7 may be stirred (shaken). In this case as well, as in application of ultrasound, an effect of removing an impurity or fine particles from underlying substrate 11 and mask layer 13 can be enhanced.

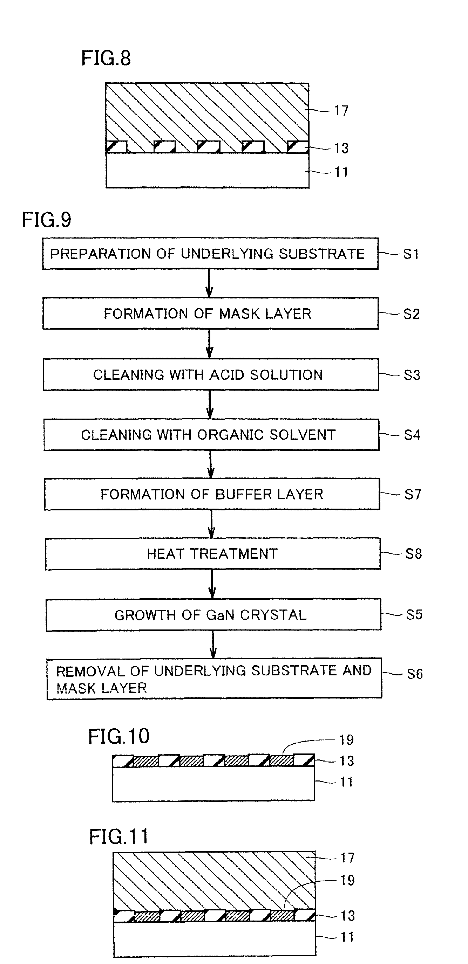

Fig. 8 is a cross-sectional view schematically showing a state where GaN crystal 17 was grown in the present embodiment. Then, as shown in Figs. 2 and 8, GaN crystal 17 is grown on underlying substrate 11 and mask layer 13 (step S5). A method of growing GaN crystal 17 is not particularly limited, and a vapor phase deposition method such as a sublimation method, an HVPE (Hydride Vapor Phase Epitaxy) method, an MOCVD (Metal Organic Chemical Vapor Deposition) method, and an MBE (Molecular Beam Epitaxy) method, a liquid phase deposition method, and the like can be adopted, and the HVPE method is preferably adopted.

GaN crystal 17 can be grown by performing steps S 1 to S5 above. In manufacturing GaN crystal 10 such as a GaN substrate shown in Fig. 1 with the use of this GaN crystal 17, the following steps are further performed.

Underlying substrate 11 and mask layer 13 are then removed from GaN crystal 17 (step S6). A removal method is not particularly limited, and for example, such a method as cutting, grinding or the like can be used.

Here, cutting refers to mechanical division into GaN crystal 17 and mask layer 13 by mechanical division (slicing) at an interface between GaN crystal 17 and mask layer 13 with the use of a slicer having a peripheral cutting edge of an electrodeposition diamond wheel, a wire saw or the like, irradiation or injection of the interface between GaN crystal 17 and mask layer 13 with laser pulses or water molecules, cleavage along a crystal lattice plane of mask layer 13, or the like. In addition, grinding refers to mechanical chipping away of underlying substrate 11 and mask layer 13 with the use of grinding facilities including a diamond wheel.

It is noted that such a chemical method as etching may be adopted as a method of removing underlying substrate 11 and mask layer 13.

In addition, though at least underlying substrate 11 and mask layer 13 are removed in order to manufacture GaN crystal 10 formed of GaN crystal 17, GaN crystal 17 in the vicinity of underlying substrate 11 and mask layer 13 may further be removed.

GaN crystal 10 shown in Fig. 1 can be manufactured by performing steps S 1 to S6 above.

It is noted that polishing may further be performed from the side of a surface of GaN crystal 10 where underlying substrate 11 has been formed. This polishing is an effective method in a case where at least one of the surface and the back surface of GaN crystal 10 should be a mirror surface, and it is a method effective for removing a process-damaged layer formed on at least one of the surface and the back surface of GaN crystal 10.

As described above, in the method of growing GaN crystal 17 and the method of manufacturing GaN crystal 10 in the present embodiment, mask layer 13 has surface roughness Rms not greater than 2 nm.

Since a surface area of mask layer 13 can thus be made smaller, the number of atoms having excess bonds, that are present at the surface of mask layer 13, can be decreased. Therefore, bonding of at least one of Ga atom and N atom to a bond of at least one of Si atom and O atom with growth of GaN crystal 17 on this mask layer 13 (step S5) can be suppressed. In addition, the number of atoms present at the surface of mask layer 13, of which crystal structure is disturbed, can also be decreased. Consequently, since formation of a GaN polycrystalline nucleus on mask layer 13 can be suppressed, GaN crystal 17 of which polycrystalline area has been made smaller can be grown.

In addition, in the method of growing GaN crystal 17 and the method of manufacturing GaN crystal 10 in the present embodiment, preferably, mask layer 13 has a radius of curvature not smaller than 8 m.

Since warp of the surface of mask layer 13 can thus be lessened, strain energy in mask layer 13 can be lowered. Therefore, bonding between at least one of Si atom and O atom in mask layer 13 and at least one of Ga atom and N atom in step S5 of growing GaN crystal 17 can be suppressed. Therefore, formation of a GaN polycrystalline nucleus on mask layer 13 can be suppressed. Thus, GaN crystal 17 of which polycrystalline area has further been made smaller can be grown.

In addition, the method of growing GaN crystal 17 and the method of manufacturing GaN crystal 10 in the present embodiment preferably include step S3 of cleaning underlying substrate 11 and mask layer 13 with an acid solution and step S4 of cleaning underlying substrate 11 and mask layer 13 with an organic solvent, between step S2 of forming mask layer 13 and step S5 of growing GaN crystal 17.

Thus, even when a reaction product or the like derived from the resist remains on underlying substrate 11 and mask layer 13 after step S2 of forming mask layer 13, the reaction product can be removed separately as divided into the hydrophilic portion and the lipophilic portion. Since the reaction product can thus be removed at the atomic level, growth of polycrystalline GaN with this reaction product serving as a nucleus can further be suppressed. Therefore, GaN crystal 17 of which polycrystalline area has further been made smaller can be grown.

### (Embodiment 2X)

GaN crystal in the present embodiment is similar to GaN crystal 10 in Embodiment 1X shown in Fig. 1.

Fig. 9 is a flowchart showing a method of manufacturing GaN crystal in the present embodiment. In succession, a method of manufacturing GaN crystal in the present embodiment will be described. As shown in Fig. 9, the method of manufacturing GaN crystal in the present embodiment is basically similar in features to the method of manufacturing GaN crystal in Embodiment 1X, however, it is different in that a buffer layer is further formed.

Specifically, initially, as shown in Figs. 3 and 9, underlying substrate 11 is prepared as in Embodiment 1X (step S1).

Then, as shown in Figs. 5 and 9, mask layer 13 is formed as in Embodiment 1X (step S2).

Then, as shown in Fig. 9, cleaning with an acid solution (step S3) and cleaning with an organic solvent (step S4) are performed as in Embodiment 1X. It is noted that these steps S3 and S4 may not be performed.

Fig. 10 is a schematic cross-sectional view showing a state where a buffer layer 19 was formed in the present embodiment. Then, as shown in Figs. 9 and 10, buffer layer 19 composed of GaN is formed on underlying substrate 11 (step 57). By forming buffer layer 19, matching of a lattice constant between underlying substrate 11 and GaN crystal 17 grown in step S5 can be good.

In the present embodiment, buffer layer 19 is grown on underlying substrate 11, in opening portion 13a in mask layer 13. A method of forming buffer layer 19 is not particularly limited, and for example, it can be formed by growth with a method similar to the method of growing GaN crystal 17.

Then, buffer layer 19 is subjected to heat treatment at a temperature not lower than 800°C and not higher than 1100°C (step S8). A temperature for heat treatment is preferably not lower than 800°C and not higher than 1100°C and further preferably around 900°C. By performing heat treatment in this temperature range, in a case where buffer layer 19 is amorphous, change from amorphous to monocrystalline can be made. In particular, in a case where underlying substrate 11 is a GaAs substrate, it is effective to form buffer layer 19 and then to subject the buffer layer to heat treatment.

It is noted that step S7 of forming buffer layer 19 and step S8 of heat treatment may not be performed. For example, in a case where underlying substrate 11 is a sapphire substrate, grown GaN crystal 17 is not much affected even though these steps S7 and S8 are not performed. On the other hand, for example, in a case where underlying substrate 11 is a GaAs substrate, good crystallinity of grown GaN crystal 17 can be achieved by performing these steps S7 and S8.

Fig. 11 is a schematic cross-sectional view showing a state where GaN crystal 17 was grown in the present embodiment. Then, as shown in Figs. 9 and 11, GaN crystal 17 is grown (step S5). In the present embodiment, GaN crystal 17 is grown on mask layer 13 and buffer layer 19. The present embodiment is otherwise the same as Embodiment 1X. GaN crystal 17 can be grown through steps S1 to S5, S7, and S8 above.

Then, as shown in Fig. 9, underlying substrate 11 and mask layer 13 are removed (step S6). In the present embodiment, buffer layer 19 is further removed. The present embodiment is otherwise the same as Embodiment 1X. GaN crystal 10 shown in Fig. 1 can be manufactured through steps S 1 to S8 above.

Since the method of growing GaN crystal 17 and the method of manufacturing GaN crystal 10 are otherwise the same as in Embodiment 1X, the same members have the same reference characters allotted and description thereof will not be repeated.

As described above, the method of growing GaN crystal 17 and the method of manufacturing GaN crystal 10 in the present embodiment further include step S7 of forming buffer layer 19 and step S8 of subjecting buffer layer 19 to heat treatment at a temperature not lower than 800°C and not higher than 1100°C, between step S2 of forming mask layer 13 and step S8 of growing GaN crystal 17.

Thus, good matching of a lattice constant between underlying substrate 11 and grown GaN crystal 17 can be achieved. Further, by subjecting buffer layer 19 to heat treatment at the temperature above, crystal in buffer layer 19 can be changed from amorphous to monocrystalline. Therefore, crystallinity of GaN crystal 17 can be improved. Thus, GaN crystal 17 of which polycrystalline area has further been made smaller can be grown.

### (Embodiment 3X)

GaN crystal in the present embodiment is similar to GaN crystal 10 in Embodiment 1X shown in Fig. 1.

In succession, a method of manufacturing GaN crystal in the present embodiment will be described. The method of manufacturing GaN crystal in the present embodiment is basically similar in features to the method of manufacturing GaN crystal in Embodiment 2X, however, it is different in that a buffer layer is formed also on a mask layer.

Specifically, as shown in Fig. 9, underlying substrate 11 is prepared as in Embodiments 1X and 2X (step S1). Then, mask layer 13 is formed as in Embodiments 1X and 2X (step S2). Then, cleaning with an acid solution (step S3) and cleaning with an organic solvent (step S4) are performed as in Embodiments 1X and 2X. It is noted that these steps S3 and S4 may not be performed.

Fig. 12 is a schematic cross-sectional view showing a state where buffer layer 19 was formed in the present embodiment. Then, as shown in Figs. 9 and 12, buffer layer 19 composed of GaN is formed on underlying substrate 11 (step S7). In the present embodiment, buffer layer 19 is grown in opening portion 13a in mask layer 13 on underlying substrate 11 as well as on mask layer 13. Namely, buffer layer 19 is grown to cover the entire mask layer 13.

Then, buffer layer 19 is subjected to heat treatment as in Embodiment 2X (step S8).

Fig. 13 is a schematic cross-sectional view showing a state where GaN crystal 17 was grown in the present embodiment. Then, as shown in Figs. 9 and 13, GaN crystal 17 is grown (step S5). In the present embodiment, GaN crystal 17 is grown on buffer layer 19. The present embodiment is otherwise the same as Embodiment 2X. GaN crystal 17 can be grown through steps S 1 to S5, S7, and S8 above.

Then, as shown in Fig. 9, underlying substrate 11 and mask layer 13 are removed (step S6). In the present embodiment, buffer layer 19 is further removed as in Embodiment 2X. GaN crystal 10 shown in Fig. 1 can be manufactured through steps S1 to S8 above.

Since the method of growing GaN crystal 17 and the method of manufacturing GaN crystal 10 are otherwise the same as in Embodiment 1X, the same members have the same reference characters allotted and description thereof will not be repeated.

As described above, according to the present embodiment, buffer layer 19 is formed to cover the entire mask layer 13. Therefore, generation of a polycrystalline nucleus on buffer layer 19 on mask layer 13 is less likely. Therefore, regarding GaN crystal 17 formed above this mask layer 13, generation of polycrystal is suppressed. In addition, since lattice matching with underlying substrate 11 can be relaxed owing to the buffer layer, crystallinity can be improved. Therefore, GaN crystal 17 of which polycrystalline area has further been made smaller and crystallinity has further been improved can be grown.

### [Example X]

In the present example, an effect of forming a mask layer having surface roughness Rms not greater than 2 nm was examined.

### (Present Inventive Examples 1X to 3X)

In Present Inventive Examples 1X to 3X, GaN crystal 17 was grown basically in accordance with Embodiment 1X described above.

Specifically, initially, underlying substrate 11 having a diameter of 60 mm and composed of sapphire was prepared (step S1).

Then, mask layer 13 composed of SiO₂ was formed on underlying substrate 11 (step S2). Specifically, SiO₂ layer 12 was vapor-deposited on underlying substrate 11 with sputtering under the conditions shown in Table 1 below. Thereafter, resist 15 was formed on SiO₂ layer 12 and it was patterned with a reactive ion etching (RIE) method, to thereby form mask layer 13 having opening portion 13a.

In step S2 of forming this mask layer 13, surface roughness Rms and a radius of curvature were measured at the time of forming the SiO₂ layer. Surface roughness Rms at 5 points in total, that is, in a central portion of the SiO₂ layer and at 4 points at positions distant by 100 µm in an upward direction, in a downward direction, in a right direction, and in a left direction from this central portion, respectively, was measured in the field of view of 10-µm square. The radius of curvature was measured as shown in Fig. 6. Table 1 below shows the results.

Then, in Present Inventive Example 2X, underlying substrate 11 and mask layer 13 were cleaned with an acid solution (step S3). Hydrofluoric acid at concentration of 25 % was employed as the acid solution and ultrasound was applied for 15 minutes at a room temperature.

Then, in each of Present Inventive Examples 1X to 3X, underlying substrate 11 and mask layer 13 were cleaned with an organic solvent (step S4). Acetone was employed as the organic solvent and ultrasound was applied for 15 minutes at a room temperature.

Then, GaN crystal 17 was grown on underlying substrate 11 and mask layer 13 with the HVPE method (step S5). Specifically, underlying substrate 11 having mask layer 13 formed was loaded into a growth furnace. Then, an ammonia (NH₃) gas, a hydrogen chloride (HCl) gas, and gallium (Ga) were prepared as source materials for GaN crystal 17, an oxygen gas was prepared as a doping gas, and hydrogen (H₂) having purity not lower than 99.999 % was prepared as a carrier gas. Then, the HCl gas and Ga were caused to react as follows: Ga + HCl → GaCl + 1/2H₂. Thus, a gallium chloride (GaCl) gas was generated. This GaCl gas and the NH₃ gas were fed together with the carrier gas and the doping gas such that they impinge on underlying substrate 11 exposed through opening portion 13a in mask layer 13 to cause reaction on that surface at 1000°C as follows: GaCl + NH₃ → GaN + HCl + H₂. It is noted that, during growth of this GaN crystal 17, a partial pressure of the HCl gas was set to 0.001 atm and a partial pressure of the NH₃ gas was set to 0.15 atm. GaN crystal 17 in Present Inventive Examples 1X to 3X was thus grown.

### (Present Inventive Examples 4X to 9X)

In Present Inventive Examples 4X to 9X, GaN crystal 17 was grown basically in accordance with Embodiment 2X described above.

Specifically, initially, underlying substrate 11 having a diameter of 60 mm and composed of GaAs was prepared (step S1).

Then, mask layer 13 composed of SiO₂ was formed on underlying substrate 11 (step S2). This step S2 was the same as in Present Inventive Examples 1X to 3X, except for sputtering under the conditions shown in Table 1 below.

Then, in Present Inventive Examples 6X to 8X, underlying substrate 11 and mask layer 13 were cleaned with an acid solution as in Present Inventive Example 2X (step S3).

Then, in Present Inventive Examples 4X to 9X, underlying substrate 11 and mask layer 13 were cleaned with an organic solvent as in Present Inventive Examples 1X and 2X (step S4).

Then, buffer layer 19 composed of GaN was formed on underlying substrate 11 with the HVPE method (step S7). Specifically, underlying substrate 11 having mask layer 13 formed was loaded into a growth furnace, and buffer layer 19 was formed under the conditions shown in Table 1 below.

Then, buffer layer 19 was subjected to heat treatment at 900°C in an atmosphere containing hydrogen and ammonia (step S8).

Then, GaN crystal 17 was grown on underlying substrate 11 and mask layer 13 with the HVPE method under the growth conditions in Table 1 below (step S5).

### (Comparative Example 1X)

Initially, an underlying substrate composed of GaAs as in Present Inventive Examples 4X to 9X was prepared (step S1).

Then, a mask layer composed of SiO₂ was formed on the underlying substrate with sputtering under the conditions shown in Table 1 below.

Then, underlying substrate 11 and mask layer 13 were cleaned with an organic solvent as in Present Inventive Examples 1X to 3X (step S4).

Then, a buffer layer was formed under the conditions shown in Table 1 below. Then, this buffer layer was subjected to heat treatment under the conditions shown in Table 1 below.

Then, GaN crystal 17 was grown on underlying substrate 11 and mask layer 13 with the HVPE method under the growth conditions in Table 1 below.

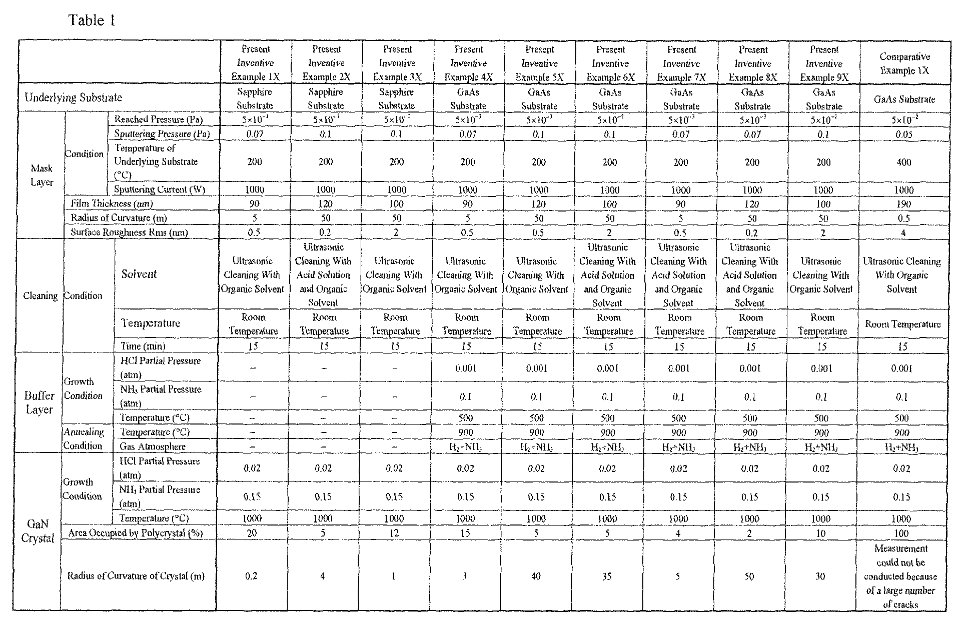

### (Measurement Method)

An area occupied by polycrystal and a radius of curvature of GaN crystal, of GaN crystal in each of Present Inventive Examples 1X to 9X and Comparative Example 1X, were measured. The area occupied by polycrystal was measured as follows. Specifically, an area having a size of 2 inches in the center was irradiated with a white LED and a portion high in reflectance was determined as polycrystal. Then, the whole area was photographed by a CCD camera. Then, the number of bits of the portion high in reflectance in the photographed image was counted and a ratio of the number of bits to the entire GaN crystal was calculated. Regarding the radius of curvature, radius R, with a curve along the surface of GaN crystal 17 being assumed as drawing an arc, was measured as in the method shown in Fig. 6.

### (Measurement Results)

As shown in Table 1, regarding GaN crystal grown in each of Present Inventive Examples 1X to 9X where a mask layer having surface roughness Rms not greater than 2 nm was formed, an area occupied by polycrystal was very low, that is, not higher than 20%.

In particular, Present Inventive Example 8X in which the mask layer had surface roughness Rms of 0.2 nm and the radius of curvature of 50 m and cleaning with an acid solution and an organic solvent was performed was very good in that an area occupied by polycrystal was 2 % and GaN crystal had the radius of curvature not smaller than 50 m.

On the other hand, in Comparative Example 1X where the mask layer had surface roughness Rms of 4 nm, an area in grown GaN crystal occupied by polycrystal was 100 %. In addition, a large number of cracks were generated and hence a radius of curvature of GaN crystal could not be measured. This may be because many atoms having bonds were present at the surface of the mask layer and at least one of Ga atom and N atom was bonded to at least one of Si atom and O atom in the mask layer during growth of GaN crystal, and thus a polycrystalline nucleus was generated.

From the foregoing, according to the present example, it could be confirmed that growth of polycrystalline GaN crystal was suppressed by forming a mask layer having surface roughness Rms not greater than 2 nm.

An embodiment of the present invention will be described hereinafter with reference to the drawings.

### (Embodiment 1Y)

Fig. 1 is a schematic cross-sectional view showing GaN crystal in the present embodiment. GaN crystal in the present embodiment will be described with reference to Fig. 1.

As shown in Fig. 1, GaN crystal 10 in the present embodiment has a main surface and a back surface opposite to this main surface. GaN crystal 10 is implemented, for example, as a substrate or an ingot.

In GaN crystal 10, an area composed of polycrystal is suppressed. For example, an area composed of polycrystal is not higher than 33 % and preferably not higher than 12 %. In addition, GaN crystal 10 has a radius of curvature preferably not smaller than 40 m and further preferably not smaller than 50 m.

Fig. 2 is a flowchart showing a method of manufacturing GaN crystal in the present embodiment. In succession, a method of manufacturing GaN crystal 10 in the present embodiment will be described with reference to Fig. 2.

Fig. 3 is a cross-sectional view schematically showing underlying substrate 11 in the present embodiment. As shown in Figs. 2 and 3, initially, underlying substrate 11 is prepared (step S1). Prepared underlying substrate 11 may be made of GaN or of a material different from GaN. For a hetero substrate made of a material different from GaN, for example, gallium arsenide (GaAs), sapphire (Al₂O₃), zinc oxide (ZnO), silicon carbide (SiC), or the like can be employed.

Fig. 4 is a cross-sectional view for illustrating a method of forming mask layer 13 in the present embodiment. Fig. 5 is a cross-sectional view schematically showing a state where mask layer 13 was formed in the present embodiment. Then, as shown in Figs. 2, 4 and 5, mask layer 13 having opening portion 13a and composed of SiO₂ is formed on the surface of underlying substrate 11 (step S2).

Step S2 of forming this mask layer 13 is performed, for example, in the following manner. As shown in Fig. 4, initially, SiO₂ layer 12 serving as a material for mask layer 13 is formed, for example, with a vapor deposition method. Then, resist 15 is formed on SiO₂ layer 12, for example, by using a coater. Then, a mask pattern is transferred to resist 15, for example, by using a stepper. Any shape such as stripes or dots can be adopted as this mask pattern. Then, a transferred portion of resist 15 is dissolved, to thereby form resist 15 having a pattern. Then, using this resist having a pattern as a mask, SiO₂ layer 12 not covered with resist 15 is etched. Opening portion 13a can thus be formed. Thereafter, resist 15 is removed. A removal method is not particularly limited, and for example, ashing or the like can be employed. Thus, as shown in Fig. 5, mask layer 13 having opening portion 13a can be formed.

Fig. 6 is a schematic diagram for illustrating a radius of curvature of mask layer 13 in the present embodiment. As shown in Fig. 6, mask layer 13 has radius of curvature R preferably not smaller than 8 m and further preferably not smaller than 50 m. When the radius of curvature is not smaller than 8 m, strain energy in mask layer 13 can be suppressed, and hence reaction between at least one of Si atom and O atom in mask layer 13 and at least one of Ga atom and N atom supplied in step S5 of growing GaN crystal which will be described later can be suppressed. Consequently, generation of a polycrystalline nucleus can be suppressed. When the radius of curvature is not smaller than 50 m, generation of a polycrystalline nucleus can further be suppressed.

Here, "radius of curvature R" above means radius R when it is assumed that a curve along a surface of mask layer 13 grown on underlying substrate 11 draws an arc, for example, as shown in Fig. 6. Regarding such a radius of curvature R, for example, a radius of curvature of SiO₂ layer 12 at the time when SiO₂ layer 12 serving as a material for mask layer 13 is formed is measured and this radius of curvature can also be adopted as the radius of curvature of mask layer 13.

Mask layer 13 has surface roughness Rms preferably not greater than 2 nm, further preferably not greater than 0.5 nm, and still further preferably not greater than 0.2 nm. When the surface roughness is not greater than 2 nm, the number of atoms having excess bonds, that are present at the surface, can be decreased. In this case, generation of a polycrystalline nucleus as a result of reaction between at least one of Si atom and O atom forming mask layer 13 and at least one of Ga atom and N atom supplied in step S5 of growing GaN crystal which will be described later can be suppressed. When the surface roughness is not greater than 0.5 nm, generation of a polycrystalline nucleus can further be suppressed. When the surface roughness is not greater than 0.2 nm, generation of a polycrystalline nucleus can still further be suppressed.

Here, "surface roughness Rms" above is a value measured in conformity with JIS B0601, with the use of an atomic force microscope (AFM), for example, in a field of view of at most 50-µm square in mask layer 13 located substantially in the center. In addition, surface roughness of a sample is preferably measured at five or more points at a pitch not greater than 10 µm in the field of view of at most 50-µm square. In this case, a value of a square root of a value calculated by averaging squares of deviation from a mean line to a traced profile in a roughness profile of this sample is defined as surface roughness Rms. In addition, in a case where it is difficult to measure surface roughness Rms depending on a size and a pitch of opening portion 13a or the like, for example, surface roughness Rms of SiO₂ layer 12 at the time when SiO₂ layer 12 serving as a material for mask layer 13 is formed can be measured and it can also be adopted as surface roughness Rms of mask layer 13.

Then, underlying substrate 11 and mask layer 13 are cleaned with an acid solution (step S3). For example, sulfuric acid, hydrofluoric acid, hydrochloric acid, or the like can be employed as the acid solution.

Since resist 15 is used as described above in step S2 of forming a mask layer, a reaction product or the like derived from the resist may remain on mask layer 13. Therefore, by cleaning with an acid solution, the reaction product remaining on underlying substrate 11 and mask layer 13 can be decomposed into a hydrophilic portion having, for example, OH group or the like and a lipophilic portion having, for example, alkyl group or the like, and the hydrophilic portion can be dissolved. Therefore, the hydrophilic portion of the reaction product can be removed.

Then, underlying substrate 11 and mask layer 13 are cleaned with an organic solvent (step S4). For example, acetone, ethanol or the like can be employed as the organic solvent.

After step S3 of cleaning with an acid solution, the lipophilic portion of the reaction product may remain. This lipophilic portion has good affinity for (is likely to blend with) an organic solvent. Therefore, by cleaning with an organic solvent, the lipophilic portion of the reaction product remaining on underlying substrate 11 and mask layer 13 can be removed.

In step S3 of cleaning with an acid solution and step S4 of cleaning with an organic solvent, the reaction product remaining on underlying substrate 11 and mask layer 13 is removed separately as divided into the hydrophilic portion and the lipophilic portion. Therefore, the reaction product derived from the resist can be removed at the atomic level.

In step S3 of cleaning with an acid solution and step S4 of cleaning with an organic solvent, ultrasound is preferably applied to the acid solution and the organic solvent. Specifically, vibration (or shaking) is applied to the acid solution and the organic solvent representing a cleaning liquid, for example, with the use of an ultrasonic apparatus as shown in Fig. 7. It is noted that Fig. 7 is a cross-sectional schematic diagram showing a treatment apparatus used in step S3 of cleaning with an acid solution and step S4 of cleaning with an organic solvent in the present embodiment. Use of ultrasound at a frequency from 900 to 2000 kHz as ultrasound is further effective.

As shown in Fig. 7, the treatment apparatus includes cleaning bath 1 for holding cleaning liquid 7 which is an acid solution or an organic solvent, ultrasound generation member 3 installed on a bottom surface of cleaning bath 1, and control unit 5 connected to ultrasound generation member 3, for controlling ultrasound generation member 3. Cleaning bath 1 holds cleaning liquid 7 therein. In addition, in cleaning liquid 7, holder 9 for holding a plurality of underlying substrates 11 each having mask layer 13 formed is immersed. Holder 9 holds a plurality of underlying substrates 11 to be cleaned, each having mask layer 13 formed. Ultrasound generation member 3 is arranged on the bottom surface of cleaning bath 1.

In cleaning underlying substrate 11 having mask layer 13 formed in step S3 of cleaning with an acid solution and step S4 of cleaning with an organic solvent, prescribed cleaning liquid 7 is arranged in cleaning bath 1 as shown in Fig. 7 and underlying substrate 11 having mask layer 13 formed, that is held by holder 9, is immersed in cleaning liquid 7, for each holder 9. Thus, the surface of mask layer 13 and underlying substrate 11 can be cleaned with cleaning liquid 7.

In addition, here, ultrasound may be generated under the control by control unit 5 of ultrasound generation member 3. Consequently, ultrasound is applied to cleaning liquid 7. Therefore, as cleaning liquid 7 vibrates, an effect of removing an impurity or fine particles from mask layer 13 and underlying substrate 11 can be enhanced. In addition, by arranging cleaning bath 1 on a member that can be shaken such as an XY stage and by shaking the member, cleaning bath 1 may be shaken to stir (shake) cleaning liquid 7 therein. Alternatively, by shaking underlying substrate 11 having mask layer 13 formed together with holder 9 with a manual operation or the like, cleaning liquid 7 may be stirred (shaken). In this case as well, as in application of ultrasound, an effect of removing an impurity or fine particles from underlying substrate 11 and mask layer 13 can be enhanced.

Fig. 8 is a cross-sectional view schematically showing a state where GaN crystal 17 was grown in the present embodiment. Then, as shown in Figs. 2 and 8, GaN crystal 17 is grown on underlying substrate 11 and mask layer 13 (step S5). A method of growing GaN crystal 17 is not particularly limited, and a vapor phase deposition method such as a sublimation method, an HVPE (Hydride Vapor Phase Epitaxy) method, an MOCVD (Metal Organic Chemical Vapor Deposition) method, and an MBE (Molecular Beam Epitaxy) method, a liquid phase deposition method, and the like can be adopted, and the HVPE method is preferably adopted.

GaN crystal 17 can be grown by performing steps S1 to S5 above. In manufacturing GaN crystal 10 such as a GaN substrate shown in Fig. 1 with the use of this GaN crystal 17, the following steps are further performed.

Underlying substrate 11 and mask layer 13 are then removed from GaN crystal 17 (step S6). A removal method is not particularly limited, and for example, such a method as cutting, grinding or the like can be used.

Here, cutting refers to mechanical division into GaN crystal 17 and mask layer 13 by mechanical division (slicing) at an interface between GaN crystal 17 and mask layer 13 with the use of a slicer having a peripheral cutting edge of an electrodeposition diamond wheel, a wire saw or the like, irradiation or injection of the interface between GaN crystal 17 and mask layer 13 with laser pulses or water molecules, cleavage along a crystal lattice plane of mask layer 13, or the like. In addition, grinding refers to mechanical chipping away of underlying substrate 11 and mask layer 13 with the use of grinding facilities including a diamond wheel.

It is noted that such a chemical method as etching may be adopted as a method of removing underlying substrate 11 and mask layer 13.

In addition, though at least underlying substrate 11 and mask layer 13 are removed in order to manufacture GaN crystal 10 formed of GaN crystal 17, GaN crystal 17 in the vicinity of underlying substrate 11 and mask layer 13 may further by removed.

GaN crystal 10 shown in Fig. 1 can be manufactured by performing steps S 1 to S6 above.

It is noted that polishing may further be performed from the side of a surface of GaN crystal 10 where underlying substrate 11 has been formed. This polishing is an effective method in a case where at least one of the surface and the back surface of GaN crystal 10 should be a mirror surface, and it is a method effective for removing a process-damaged layer formed on at least one of the surface and the back surface of GaN crystal 10.

As described above, in the method of growing GaN crystal 17 and the method of manufacturing GaN crystal 10 in the present embodiment, mask layer 13 has a radius of curvature not smaller than 8 m.

Since warp of the surface of mask layer 13 can thus be lessened, strain energy in mask layer 13 can be lowered. Therefore, bonding between at least one of Si atom and O atom in mask layer 13 and at least one of Ga atom and N atom in step S5 of growing GaN crystal 17 can be suppressed. Therefore, formation of a GaN polycrystalline nucleus on mask layer 13 can be suppressed. Thus, GaN crystal 17 of which polycrystalline area has further been made smaller can be grown.

In addition, the method of growing GaN crystal 17 and the method of manufacturing GaN crystal 10 in the present embodiment preferably include step S3 of cleaning underlying substrate 11 and mask layer 13 with an acid solution and step S4 of cleaning underlying substrate 11 and mask layer 13 with an organic solvent, between step S2 of forming mask layer 13 and step S5 of growing GaN crystal 17.

Thus, even when a reaction product or the like derived from the resist remains on underlying substrate 11 and mask layer 13 after step S2 of forming mask layer 13, the reaction product can be removed separately as divided into the hydrophilic portion and the lipophilic portion. Since the reaction product can thus be removed at the atomic level, growth of polycrystalline GaN with this reaction product serving as a nucleus can further be suppressed. Therefore, GaN crystal 17 of which polycrystalline area has further been made smaller can be grown.

In addition, in the method of growing GaN crystal 17 and the method of manufacturing GaN crystal 10 in the present embodiment, preferably, mask layer 13 has surface roughness Rms not greater than 2 nm.

Since a surface area of mask layer 13 can thus be made smaller, the number of atoms having excess bonds, that are present at the surface of mask layer 13, can be decreased. Therefore, bonding of at least one of Ga atom and N atom to a bond of at least one of Si atom and O atom with growth of GaN crystal 17 on this mask layer 13 (step S5) can be suppressed. In addition, the number of atoms present at the surface of mask layer 13, of which crystal structure is disturbed, can also be decreased. Consequently, since formation of a GaN polycrystalline nucleus on mask layer 13 can be suppressed, GaN crystal 17 of which polycrystalline area has been made smaller can further be grown.

### (Embodiment 2Y)

GaN crystal in the present embodiment is similar to GaN crystal 10 in Embodiment 1Y shown in Fig. 1.

Fig. 9 is a flowchart showing a method of manufacturing GaN crystal in the present embodiment. In succession, a method of manufacturing GaN crystal in the present embodiment will be described. As shown in Fig. 9, the method of manufacturing GaN crystal in the present embodiment is basically similar in features to the method of manufacturing GaN crystal in Embodiment 1Y, however, it is different in that a buffer layer is further formed.

Specifically, initially, as shown in Figs. 3 and 9, underlying substrate 11 is prepared as in Embodiment 1 Y (step S1).

Then, as shown in Figs. 5 and 9, mask layer 13 is formed as in Embodiment 1Y (step S2).

Then, as shown in Fig. 9, cleaning with an acid solution (step S3) and cleaning with an organic solvent (step S4) are performed as in Embodiment 1Y. It is noted that these steps S3 and S4 may not be performed.

Fig. 10 is a schematic cross-sectional view showing a state where buffer layer 19 was formed in the present embodiment. Then, as shown in Figs. 9 and 10, buffer layer 19 composed of GaN is formed on underlying substrate 11 (step S7). By forming buffer layer 19, matching of a lattice constant between underlying substrate 11 and GaN crystal 17 grown in step S5 can be good.

In the present embodiment, buffer layer 19 is grown on underlying substrate 11, in opening portion 13a in mask layer 13. A method of forming buffer layer 19 is not particularly limited, and for example, it can be formed by growth with a method similar to the method of growing GaN crystal 17.

Then, buffer layer 19 is subjected to heat treatment at a temperature not lower than 800°C and not higher than 1100°C (step S8). A temperature for heat treatment is preferably not lower than 800°C and not higher than 1100°C and further preferably around 900°C. By performing heat treatment in this temperature range, in a case where buffer layer 19 is amorphous, change from amorphous to monocrystalline can be made. In particular, in a case where underlying substrate 11 is a GaAs substrate, it is effective to form buffer layer 19 and then to subject the buffer layer to heat treatment.

It is noted that step S7 of forming buffer layer 19 and step S8 of heat treatment may not be performed. For example, in a case where underlying substrate 11 is a sapphire substrate, grown GaN crystal 17 is not much affected even though these steps S7 and S8 are not performed. On the other hand, for example, in a case where underlying substrate 11 is a GaAs substrate, good crystallinity of grown GaN crystal 17 can be achieved by performing these steps S7 and S8.

Fig. 11 is a schematic cross-sectional view showing a state where GaN crystal 17 was grown in the present embodiment. Then, as shown in Figs. 9 and 11, GaN crystal 17 is grown (step S5). In the present embodiment, GaN crystal 17 is grown on mask layer 13 and buffer layer 19. The present embodiment is otherwise the same as Embodiment 1Y. GaN crystal 17 can be grown through steps S1 to S5, S7, and S8 above.

Then, as shown in Fig. 9, underlying substrate 11 and mask layer 13 are removed (step S6). In the present embodiment, buffer layer 19 is further removed. The present embodiment is otherwise the same as Embodiment 1Y. GaN crystal 10 shown in Fig. 1 can be manufactured through steps S1 to S8 above.

Since the method of growing GaN crystal 17 and the method of manufacturing GaN crystal 10 are otherwise the same as in Embodiment 1Y, the same members have the same reference characters allotted and description thereof will not be repeated.

As described above, the method of growing GaN crystal 17 and the method of manufacturing GaN crystal 10 in the present embodiment further include step S7 of forming buffer layer 19 and step S8 of subjecting buffer layer 19 to heat treatment at a temperature not lower than 800°C and not higher than 1100°C, between step S2 of forming mask layer 13 and step S8 of growing GaN crystal 17.

Thus, good matching of a lattice constant between underlying substrate 11 and grown GaN crystal 17 can be achieved. Further, by subjecting buffer layer 19 to heat treatment at the temperature above, crystal in buffer layer 19 can be changed from amorphous to monocrystalline. Therefore, crystallinity of GaN crystal 17 can be improved. Thus, GaN crystal 17 of which polycrystalline area has further been made smaller can be grown.

### (Embodiment 3Y)

GaN crystal in the present embodiment is similar to GaN crystal 10 in Embodiment 1Y shown in Fig. 1.

In succession, a method of manufacturing GaN crystal in the present embodiment will be described. The method of manufacturing GaN crystal in the present embodiment is basically similar in features to the method of manufacturing GaN crystal in Embodiment 2Y, however, it is different in that a buffer layer is formed also on a mask layer.

Specifically, as shown in Fig. 9, underlying substrate 11 is prepared as in Embodiments 1Y and 2Y (step S1). Then, mask layer 13 is formed as in Embodiments 1Y and 2Y (step S2). Then, cleaning with an acid solution (step S3) and cleaning with an organic solvent (step S4) are performed as in Embodiments 1Y and 2Y. It is noted that these steps S3 and S4 may not be performed.

Fig. 12 is a schematic cross-sectional view showing a state where buffer layer 19 was formed in the present embodiment. Then, as shown in Figs. 9 and 12, buffer layer 19 composed of GaN is formed on underlying substrate 11 (step S7). In the present embodiment, buffer layer 19 is grown in opening portion 13a in mask layer 13 on underlying substrate 11 as well as on mask layer 13. Namely, buffer layer 19 is grown to cover the entire mask layer 13.

Then, buffer layer 19 is subjected to heat treatment as in Embodiment 2Y (step S8).

Fig. 13 is a schematic cross-sectional view showing a state where GaN crystal 17 was grown in the present embodiment. Then, as shown in Figs. 9 and 13, GaN crystal 17 is grown (step S5). In the present embodiment, GaN crystal 17 is grown on buffer layer 19. The present embodiment is otherwise the same as Embodiment 2Y. GaN crystal 17 can be grown through steps S 1 to S5, S7, and S8 above.

Then, as shown in Fig. 9, underlying substrate 11 and mask layer 13 are removed (step S6). In the present embodiment, buffer layer 19 is further removed as in Embodiment 2Y. GaN crystal 10 shown in Fig. 1 can be manufactured through steps S1 to S8 above.

Since the method of growing GaN crystal 17 and the method of manufacturing GaN crystal 10 are otherwise the same as in Embodiment 1Y, the same members have the same reference characters allotted and description thereof will not be repeated.

As described above, according to the present embodiment, buffer layer 19 is formed to cover the entire mask layer 13. Therefore, generation of a polycrystalline nucleus on buffer layer 19 on mask layer 13 is less likely. Therefore, regarding GaN crystal 17 formed above this mask layer 13, generation of polycrystal is suppressed. In addition, since lattice matching with underlying substrate 11 can be relaxed owing to buffer layer 19, crystallinity can be improved. Therefore, GaN crystal 17 of which polycrystalline area has further been made smaller and crystallinity has further been improved can be grown.

### [Example Y]

In the present example, an effect of forming a mask layer having a radius of curvature not smaller than 8 m was examined.

### (Present Inventive Examples 1Y and 2Y)

In Present Inventive Examples I Y and 2Y, GaN crystal 17 was grown basically in accordance with Embodiment 1Y described above.

Specifically, initially, underlying substrate 11 having a diameter of 60 mm and composed of sapphire was prepared (step S1).

Then, mask layer 13 composed of SiO₂ was formed on underlying substrate 11 (step S2). Specifically, SiO₂ layer 12 was vapor-deposited on underlying substrate 11 with sputtering under the conditions shown in Table 2 below. Thereafter, resist 15 was formed on SiO₂ layer 12 and it was patterned with a reactive ion etching (RIE) method, to thereby form mask layer 13 having opening portion 13a.

In step S2 of forming this mask layer 13, surface roughness Rms and a radius of curvature were measured at the time of forming the SiO₂ layer. Surface roughness Rms at 5 points in total, that is, in a central portion of the SiO₂ layer and at 4 points at positions distant by 100 µm in an upward direction, in a downward direction, in a right direction, and in a left direction from this central portion, respectively, was measured in the field of view of 10-µm square. The radius of curvature was measured as shown in Fig. 6. Table 2 below shows the results.

Then, in Present Inventive Example 1Y, underlying substrate 11 and mask layer 13 were cleaned with an acid solution (step S3). Hydrofluoric acid at concentration of 25 % was employed as the acid solution and ultrasound was applied for 15 minutes at a room temperature.

Then, in each of Present Inventive Examples 1Y and 2Y, underlying substrate 11 and mask layer 13 were cleaned with an organic solvent (step S4). Acetone was employed as the organic solvent and ultrasound was applied for 15 minutes at a room temperature.

Then, GaN crystal 17 was grown on underlying substrate 11 and mask layer 13 with the HVPE method (step S5). Specifically, underlying substrate 11 having mask layer 13 formed was loaded into a growth furnace. Then, an ammonia (NH₃) gas, a hydrogen chloride (HCl) gas, and gallium (Ga) were prepared as source materials for GaN crystal 17, an oxygen gas was prepared as a doping gas, and hydrogen (H₂) having purity not lower than 99.999 % was prepared as a carrier gas. Then, the HCl gas and Ga were caused to react as follows: Ga + HCl → GaCl + 1/2H₂. Thus, a gallium chloride (GaCl) gas was generated. This GaCl gas and the NE₃ gas were fed together with the carrier gas and the doping gas such that they impinge on underlying substrate 11 exposed through opening portion 13a in mask layer 13 to cause reaction on that surface at 1000°C as follows: GaCl + NH₃ → GaN + HCl + H₂. It is noted that, during growth of this GaN crystal 17, a partial pressure of the HCl gas was set to 0.001 atm and a partial pressure of the NH₃ gas was set to 0.15 atm. GaN crystal 17 in Present Inventive Examples 1 Y and 2Y was thus grown.

### (Present Inventive Examples 3Y to 7Y)

In Present Inventive Examples 3Y to 7Y, GaN crystal 17 was grown basically in accordance with Embodiment 2Y described above.

Specifically, initially, underlying substrate 11 having a diameter of 60 mm and composed of GaAs was prepared (step S 1).

Then, mask layer 13 composed of SiO₂ was formed on underlying substrate 11 (step S2). This step S2 was the same as in Present Inventive Examples 1 Y and 2Y, except for sputtering under the conditions shown in Table 2 below.

Then, in Present Inventive Examples 3Y, 5Y and 6Y, underlying substrate 11 and mask layer 13 were cleaned with an acid solution as in Present Inventive Example 2Y (step S3).

Then, in Present Inventive Examples 3Y to 7Y, underlying substrate 11 and mask layer 13 were cleaned with an organic solvent as in Present Inventive Examples 1Y and 2Y (step S4).

Then, buffer layer 19 composed of GaN was formed on underlying substrate 11 with the HVPE method (step S7). Specifically, underlying substrate 11 having mask layer 13 formed was loaded into a growth furnace, and buffer layer 19 was formed under the conditions shown in Table 2 below.

Then, buffer layer 19 was subjected to heat treatment at 900°C in an atmosphere containing hydrogen and ammonia (step S8).

Then, GaN crystal 17 was grown on underlying substrate 11 and mask layer 13 with the HVPE method under the growth conditions in Table 2 below (step S5).

### (Comparative Example 1Y)

Initially, an underlying substrate composed of GaAs as in Present Inventive Examples 3Y to 7Y was prepared (step S1).

Then, a mask layer composed of SiO₂ was formed on the underlying substrate with sputtering under the conditions shown in Table 2 below.

Then, underlying substrate 11 and mask layer 13 were cleaned with an organic solvent as in Present Inventive Examples 1Y to 3Y (step S4).

Then, a buffer layer was formed under the conditions shown in Table 2 below. Then, this buffer layer was subjected to heat treatment under the conditions shown in Table 2 below.

Then, GaN crystal was grown on underlying substrate 11 and mask layer 13 with the HVPE method under the growth conditions in Table 2 below.

**Table 2**

| | | | Present Inventive Example 1Y | Present Inventive Example 2Y | Present Inventive Example 3Y | Present Inventive Example 4Y | Present Inventive Example 5Y | Present Inventive Example 6Y | Present Inventive Example 7Y | Comparative Example 1Y |
|---|---|---|---|---|---|---|---|---|---|---|
| Underlying Substrate | | | Sapphire Substrate | Sapphire Substrate | GaAs Substrate | GaAs Substrate | GaAs Substrate | GaAs Substrate | GaAs Substrate | GaAs Substrate |
| Mask Layer | Condition | Reached Pressure (Pa) | 5×10⁻³ | 5×10⁻² | 5×10⁻³ | 5×10⁻³ | 5×10⁻² | 5×10⁻³ | 5×10⁻² | 5×10⁻² |
| | | Sputtering Pressure (Pa) | 0.1 | 0.1 | 0.1 | 0.1 | 0.1 | 0.07 | 0.1 | 0.05 |
| | | Temperature of Underlying Substrate (°C) | 200 | 200 | 400 | 200 | 200 | 200 | 200 | 400 |
| | | Sputtering Current (W) | 1000 | 1000 | 1000 | 1000 | 1000 | 1000 | 1000 | 1000 |
| | Film Thickness (nm) | | 120 | 100 | 230 | 120 | 100 | 120 | 100 | 190 |
| | Radius of Curvature (m) | | 50 | 50 | 8 | 50 | 50 | 50 | 50 | 0.5 |
| | Surface Roughness Rms (nm) | | 0.2 | 2 | 5 | 0.5 | 2 | 0.2 | 2 | 4 |
| Cleaning | Condition | Solvent | Ultrasonic Cleaning With Acid Solution and Organic Solvent | Ultrasonic Cleaning With Organic Solvent | Ultrasonic Cleaning With Acid Solution and Organic Solvent | Ultrasonic Cleaning With Organic Solvent | Ultrasonic Cleaning With Acid Solution and Organic Solvent | Ultrasonic Cleaning With Acid Solution and Organic Solvent | Ultrasonic Cleaning With Organic Solvent | Ultrasonic Cleaning With Organic Solvent |
| | | Temperature | Room Temperature | Room Temperature | Room Temperature | Room Temperature | Room Temperature | Room Temperature | Room Temperature | Room Temperature |
| | | Time (min) | 15 | 15 | 15 | 15 | 15 | 15 | 15 | 15 |
| Buffer Layer | Growth Condition | HCl Partial Pressure | - | - | 0.001 | 0.001 | 0.001 | 0.001 | 0.001 | 0.001 |
| | | (atm) NH₃ Partial Pressure (atm) | - | - | 0.1 | 0.1 | 0.1 | 0.1 | 0.1 | 0.1 |
| | | Temperature (°C) | - | - | 500 | 500 | 500 | 500 | 500 | 500 |
| | Annealing Condition | Temperature (°C) | - | - | 900 | 900 | 900 | 900 | 900 | 900 |
| | | Gas Atmosphere | - | - | H₂+NH₃ | H₂+NH₃ | H₂+NH₃ | H₂+NH₃ | H₂+N₃ | H₂+NH₃ |
| GaN Crystal | Growth Condition | HCl Partial Pressure (atm) | 0.02 | 0.02 | 0.02 | 0.02 | 0.02 | 0.02 | 0.02 | 0.02 |
| | | NH₃ Partial Pressure (atm) | 0.15 | 0.15 | 0.15 | 0.15 | 0.15 | 0.15 | 0.15 | 0.15 |
| | | Temperature (°C) | 1000 | 1000 | 1000 | 1000 | 1000 | 1000 | 1000 | 1000 |
| | Area Occupied by Polycrystal (%) | | 5 | 12 | 33 | 5 | 5 | 2 | 10 | 100 |
| | Radius of Curvature of Crystal (m) | | 4 | 1 | 0.5 | 40 | 35 | 50 | 30 | Measurement could not be conducted because of many cracks |

### (Measurement Method)

An area occupied by polycrystal and a radius of curvature of GaN crystal, of GaN crystal in each of Present Inventive Examples 1Y to 7Y and Comparative Example 1Y were measured. The area occupied by polycrystal was measured as follows. Specifically, an area having a size of 2 inches in the center was irradiated with a white LED and a portion high in reflectance was determined as polycrystal. Then, the whole area was photographed by a CCD camera. Then, the number of bits of the portion high in reflectance in the photographed image was counted and a ratio of the number of bits to the entire GaN crystal was calculated. Regarding the radius of curvature, radius R, with a curve along the surface of GaN crystal 17 being assumed as drawing an arc, was measured as in the method shown in Fig. 6.

### (Measurement Results)

As shown in Table 2, regarding GaN crystal grown in each of Present Inventive Examples 1Y to 7Y where a mask layer having a radius of curvature not smaller than 8 m was formed, an area occupied by polycrystal was very low, that is, not higher than 33 %. In particular, regarding GaN crystal in each of Present Inventive Examples 1Y, 2Y, and 4Y to 7Y having a radius of curvature not smaller than 50 m, an area occupied by polycrystal was very low, that is, not higher than 12 %.

On the other hand, in Comparative Example 1Y where the mask layer had a radius of curvature of 0.5 m, an area in grown GaN crystal occupied by polycrystal was 100 %. In addition, a large number of cracks were generated and hence a radius of curvature of GaN crystal could not be measured. This may be because the mask layer had a large radius of curvature and hence strain energy was great, and thus at least one of Ga atom and N atom was bonded to at least one of Si atom and O atom in the mask layer during growth of GaN crystal and a polycrystalline nucleus was generated.

From the foregoing, according to the present example, it could be confirmed that growth of polycrystalline GaN crystal was suppressed by forming a mask layer having a radius of curvature not smaller than 8 m.

An embodiment of the present invention will be described hereinafter with reference to the drawings.

### (Embodiment 1Z)

Fig. 1 is a schematic cross-sectional view showing GaN crystal in the present embodiment. GaN crystal in the present embodiment will be described with reference to Fig. 1.

As shown in Fig. 1, GaN crystal 10 in the present embodiment has a main surface and a back surface opposite to this main surface. GaN crystal 10 is implemented, for example, as a substrate or an ingot.

In GaN crystal 10, an area composed of polycrystal is suppressed. For example, an area composed of polycrystal is not higher than 33 %, preferably not higher than 12 %, and further preferably not higher than 5 %. In addition, GaN crystal 10 has a radius of curvature preferably not smaller than 35 m and further preferably not smaller than 50 m

Fig. 2 is a flowchart showing a method of manufacturing GaN crystal in the present embodiment. In succession, a method of manufacturing GaN crystal 10 in the present embodiment will be described with reference to Fig. 2.

Fig. 3 is a cross-sectional view schematically showing underlying substrate 11 in the present embodiment. As shown in Figs. 2 and 3, initially, underlying substrate 11 is prepared (step S1). Prepared underlying substrate 11 may be made of GaN or of a material different from GaN. For a hetero substrate made of a material different from GaN, for example, gallium arsenide (GaAs), sapphire (Al₂O₃), zinc oxide (ZnO), silicon carbide (SiC), or the like can be employed.

Fig. 4 is a cross-sectional view for illustrating a method of forming mask layer 13 in the present embodiment. Fig. 5 is a cross-sectional view schematically showing a state where mask layer 13 was formed in the present embodiment. Then, as shown in Figs. 2, 4 and 5, mask layer 13 having opening portion 13a and composed of SiO₂ is formed on the surface of underlying substrate 11 (step S2).

Step S2 of forming this mask layer 13 is performed, for example, in the following manner. As shown in Fig. 4, initially, SiO₂ layer 12 serving as a material for mask layer 13 is formed, for example, with a vapor deposition method. Then, resist 15 is formed on SiO₂ layer 12, for example, by using a coater. Then, a mask pattern is transferred to resist 15, for example, by using a stepper. Any shape such as stripes or dots can be adopted as this mask pattern. Then, a transferred portion of resist 15 is dissolved, to thereby form resist 15 having a pattern. Then, using this resist having a pattern as a mask, SiO₂ layer 12 not covered with resist 15 is etched. Opening portion 13a can thus be formed. Thereafter, resist 15 is removed. A removal method is not particularly limited, and for example, ashing or the like can be employed. Thus, as shown in Fig. 5, mask layer 13 having opening portion 13a can be formed.

Though mask layer 13 in the present embodiment is implemented by SiO₂ layer 12, a material for mask layer 13 is not limited to SiO₂, and for example, it may be SiN (silicon nitride) or the like.

In a case where mask layer 13 is composed of SiO₂, mask layer 13 has surface roughness Rms preferably not greater than 2 nm, further preferably not greater than 0.5 nm, and still further preferably not greater than 0.2 nm. When the surface roughness is not greater than 2 nm, the number of atoms having excess bonds, that are present at the surface, can be decreased. In this case, generation of a polycrystalline nucleus as a result of reaction between at least one of Si atom and O atom and at least one of Ga atom and N atom supplied in step S5 of growing GaN crystal which will be described later can be suppressed. When the surface roughness is not greater than 0.5 nm, generation of a polycrystalline nucleus can further be suppressed. When the surface roughness is not greater than 0.2 nm, generation of a polycrystalline nucleus can still further be suppressed.

Here, "surface roughness Rms" above is a value measured in conformity with JIS B0601, with the use of an atomic force microscope (AFM), for example, in a field of view of at most 50-µm square in mask layer 13 located substantially in the center. In addition, surface roughness of a sample is preferably measured at five or more points at a pitch not greater than 10 µm in the field of view of at most 50-µm square. In this case, a value of a square root of a value calculated by averaging squares of deviation from a mean line to a traced profile in a roughness profile of this sample is defined as surface roughness Rms. In addition, in a case where it is difficult to measure surface roughness Rms depending on a size and a pitch of opening portion 13a or the like, for example, surface roughness Rms of SiO₂ layer 12 at the time when SiO₂ layer 12 serving as a material for mask layer 13 is formed can be measured and it can also be adopted as surface roughness Rms of mask layer 13.

Fig. 6 is a schematic diagram for illustrating a radius of curvature of mask layer 13 in the present embodiment. As shown in Fig. 6, in a case where mask layer 13 is composed of SiO₂, mask layer 13 has radius of curvature R preferably not smaller than 8 m and further preferably not smaller than 50 m. When the radius of curvature is not smaller than 8 m, strain energy in mask layer 13 can be suppressed, and hence reaction between at least one of Si atom and O atom in mask layer 13 and at least one of Ga atom and N atom supplied in step S5 of growing GaN crystal which will be described later can be suppressed. Consequently, generation of a polycrystalline nucleus can be suppressed. When the radius of curvature is not smaller than 50 m, generation of a polycrystalline nucleus can further be suppressed.

Here, "radius of curvature R" above means radius R when it is assumed that a curve along a surface of mask layer 13 grown on underlying substrate 11 draws an arc, for example, as shown in Fig. 6. Regarding such a radius of curvature R, for example, a radius of curvature of SiO₂ layer 12 at the time when SiO₂ layer 12 serving as a material for mask layer 13 is formed is measured and this radius of curvature can also be adopted as the radius of curvature of mask layer 13.

Then, underlying substrate 11 and mask layer 13 are cleaned with an acid solution (step S3). For example, sulfuric acid, hydrofluoric acid, hydrochloric acid, or the like can be employed as the acid solution.

Since resist 15 is used as described above in step S2 of forming a mask layer, a reaction product or the like derived from the resist may remain on mask layer 13. Therefore, by cleaning with an acid solution, the reaction product remaining on underlying substrate 11 and mask layer 13 can be decomposed into a hydrophilic portion having, for example, OH group or the like and a lipophilic portion having, for example, alkyl group or the like, and the hydrophilic portion can be dissolved. Therefore, the hydrophilic portion of the reaction product can be removed.

Then, underlying substrate 11 and mask layer 13 are cleaned with an organic solvent (step S4). For example, acetone, ethanol or the like can be employed as the organic solvent.

After step S3 of cleaning with an acid solution, the lipophilic portion of the reaction product may remain. This lipophilic portion has good affinity for (is likely to blend with) an organic solvent. Therefore, by cleaning with an organic solvent, the lipophilic portion of the reaction product remaining on underlying substrate 11 and mask layer 13 can be removed.

In step S3 of cleaning with an acid solution and step S4 of cleaning with an organic solvent, the reaction product remaining on underlying substrate 11 and mask layer 13 is removed separately as divided into the hydrophilic portion and the lipophilic portion. Therefore, the reaction product derived from the resist can be removed at the atomic level.

In step S3 of cleaning with an acid solution and step S4 of cleaning with an organic solvent, ultrasound is preferably applied to the acid solution and the organic solvent. Specifically, vibration (or shaking) is applied to the acid solution and the organic solvent representing a cleaning liquid, for example, with the use of an ultrasonic apparatus as shown in Fig. 7. It is noted that Fig. 7 is a cross-sectional schematic diagram showing a treatment apparatus used in step S3 of cleaning with an acid solution and step S4 of cleaning with an organic solvent in the present embodiment. Use of ultrasound at a frequency from 900 to 2000 kHz as ultrasound is further effective.

As shown in Fig. 7, the treatment apparatus includes cleaning bath 1 for holding cleaning liquid 7 which is an acid solution or an organic solvent, ultrasound generation member 3 installed on a bottom surface of cleaning bath 1, and control unit 5 connected to ultrasound generation member 3, for controlling ultrasound generation member 3. Cleaning bath 1 holds cleaning liquid 7 therein. In addition, in cleaning liquid 7, holder 9 for holding a plurality of underlying substrates 11 each having mask layer 13 formed is immersed. Holder 9 holds a plurality of underlying substrates 11 to be cleaned, each having mask layer 13 formed. Ultrasound generation member 3 is arranged on the bottom surface of cleaning bath 1.

In cleaning underlying substrate 11 having mask layer 13 formed in step S3 of cleaning with an acid solution and step S4 of cleaning with an organic solvent, prescribed cleaning liquid 7 is arranged in cleaning bath 1 as shown in Fig. 7 and underlying substrate 11 having mask layer 13 formed, that is held by holder 9, is immersed in cleaning liquid 7, for each holder 9. Thus, the surface of mask layer 13 and underlying substrate 11 can be cleaned with cleaning liquid 7.

In addition, here, ultrasound may be generated under the control by control unit 5 of ultrasound generation member 3. Consequently, ultrasound is applied to cleaning liquid 7. Therefore, as cleaning liquid 7 vibrates, an effect of removing an impurity or fine particles from mask layer 13 and underlying substrate 11 can be enhanced. In addition, by arranging cleaning bath 1 on a member that can be shaken such as an XY stage and by shaking the member, cleaning bath 1 may be shaken to stir (shake) cleaning liquid 7 therein. Alternatively, by shaking underlying substrate 11 having mask layer 13 formed together with holder 9 with a manual operation or the like, cleaning liquid 7 may be stirred (shaken). In this case as well, as in application of ultrasound, an effect of removing an impurity or fine particles from underlying substrate 11 and mask layer 13 can be enhanced.

Fig. 8 is a cross-sectional view schematically showing a state where GaN crystal 17 was grown in the present embodiment. Then, as shown in Figs. 2 and 8, GaN crystal 17 is grown on underlying substrate 11 and mask layer 13 (step S5). A method of growing GaN crystal 17 is not particularly limited, and a vapor phase deposition method such as a sublimation method, an HVPE (Hydride Vapor Phase Epitaxy) method, an MOCVD (Metal Organic Chemical Vapor Deposition) method, and an MBE (Molecular Beam Epitaxy) method, a liquid phase deposition method, and the like can be adopted, and the HVPE method is preferably adopted.

GaN crystal 17 can be grown by performing steps S1 to S5 above. In manufacturing GaN crystal 10 such as a GaN substrate shown in Fig. 1 with the use of this GaN crystal 17, the following steps are further performed.

Underlying substrate 11 and mask layer 13 are then removed from GaN crystal 17 (step S6). A removal method is not particularly limited, and for example, such a method as cutting, grinding or the like can be used.

Here, cutting refers to mechanical division into GaN crystal 17 and mask layer 13 by mechanical division (slicing) at an interface between GaN crystal 17 and mask layer 13 with the use of a slicer having a peripheral cutting edge of an electrodeposition diamond wheel, a wire saw or the like, irradiation or injection of the interface between GaN crystal 17 and mask layer 13 with laser pulses or water molecules, cleavage along a crystal lattice plane of mask layer 13, or the like. In addition, grinding refers to mechanical chipping away of underlying substrate 11 and mask layer 13 with the use of grinding facilities including a diamond wheel.

It is noted that such a chemical method as etching may be adopted as a method of removing underlying substrate 11 and mask layer 13.

In addition, though at least underlying substrate 11 and mask layer 13 are removed in order to manufacture GaN crystal 10 formed of GaN crystal 17, GaN crystal 17 in the vicinity of underlying substrate 11 and mask layer 13 may further by removed.

GaN crystal 10 shown in Fig. 1 can be manufactured by performing steps S1 to S6 above.

It is noted that polishing may further be performed from the side of a surface of GaN crystal 10 where underlying substrate 11 has been formed. This polishing is an effective method in a case where at least one of the surface and the back surface of GaN crystal 10 should be a mirror surface, and it is a method effective for removing a process-damaged layer formed on at least one of the surface and the back surface of GaN crystal 10.

As described above, the method of growing GaN crystal 17 and the method of manufacturing GaN crystal 10 in the present embodiment include step S3 of cleaning underlying substrate 11 and mask layer 13 with an acid solution and step S4 of cleaning underlying substrate 11 and mask layer 13 with an organic solvent after step S3 of cleaning with an acid solution.

Thus, even when a reaction product or the like derived from the resist remains on underlying substrate 11 and mask layer 13 after step S2 of forming mask layer 13, the reaction product derived from the resist can be removed separately as divided into the hydrophilic portion and the lipophilic portion. Since the reaction product can thus be removed at the atomic level, growth of polycrystalline GaN with this reaction product serving as a nucleus can further be suppressed. Therefore, GaN crystal 17 of which polycrystalline area has been made smaller can be grown.

In addition, in the method of growing GaN crystal 17 and the method of manufacturing GaN crystal 10 in the present embodiment, preferably, mask layer 13 has surface roughness Rms not greater than 2 nm.

Since a surface area of mask layer 13 can thus be made smaller, the number of atoms having excess bonds, that are present at the surface of mask layer 13, can be decreased. Therefore, bonding of at least one of Ga atom and N atom to a bond of at least one of Si atom and O atom at the time when GaN crystal 17 is grown on this mask layer 13 (step S5) can be suppressed. In addition, the number of atoms present at the surface of mask layer 13, of which crystal structure is disturbed, can also be decreased. Consequently, since formation of a GaN polycrystalline nucleus on mask layer 13 can be suppressed, GaN crystal 17 of which polycrystalline area has further been made smaller can be grown.

In addition, in the method of growing GaN crystal 17 and the method of manufacturing GaN crystal 10 in the present embodiment, preferably, mask layer 13 has a radius of curvature not smaller than 8 m.

Since warp of the surface of mask layer 13 can thus be lessened, strain energy in mask layer 13 can be lowered. Therefore, bonding between at least one of Si atom and O atom in mask layer 13 and at least one of Ga atom and N atom in step S5 of growing GaN crystal 17 can be suppressed. Therefore, formation of a GaN polycrystalline nucleus on mask layer 13 can be suppressed. Thus, GaN crystal 17 of which polycrystalline area has further been made smaller can be grown.

### (Embodiment 2Z)

GaN crystal in the present embodiment is similar to GaN crystal 10 in Embodiment 1Z shown in Fig. 1.

Fig. 9 is a flowchart showing a method of manufacturing GaN crystal in the present embodiment. In succession, a method of manufacturing GaN crystal in the present embodiment will be described. As shown in Fig. 9, the method of manufacturing GaN crystal in the present embodiment is basically similar in features to the method of manufacturing GaN crystal in Embodiment 1Z, however, it is different in that a buffer layer is further formed.

Specifically, initially, as shown in Figs. 3 and 9, underlying substrate 11 is prepared as in Embodiment 1Z (step S1).

Then, as shown in Figs. 5 and 9, mask layer 13 is formed as in Embodiment 1Z (step S2).

Then, as shown in Fig. 9, cleaning with an acid solution (step S3) and cleaning with an organic solvent (step S4) are performed as in Embodiment 1Z.

Fig. 10 is a schematic cross-sectional view showing a state where buffer layer 19 was formed in the present embodiment. Then, as shown in Figs. 9 and 10, buffer layer 19 composed of GaN is formed on underlying substrate 11 (step S7). By forming buffer layer 19, matching of a lattice constant between underlying substrate 11 and GaN crystal 17 grown in step S5 can be good.

In the present embodiment, buffer layer 19 is grown on underlying substrate 11, in opening portion 13a in mask layer 13. A method of forming buffer layer 19 is not particularly limited, and for example, it can be formed by growth with a method similar to the method of growing GaN crystal 17.

Then, buffer layer 19 is subjected to heat treatment at a temperature not lower than 800°C and not higher than 1100°C (step S8). A temperature for heat treatment is preferably not lower than 800°C and not higher than 1100°C and further preferably around 900°C. By performing heat treatment in this temperature range, in a case where buffer layer 19 is amorphous, change from amorphous to monocrystalline can be made. In particular, in a case where underlying substrate 11 is a GaAs substrate, it is effective to form buffer layer 19 and then to subject the buffer layer to heat treatment.

It is noted that step S7 of forming buffer layer 19 and step S8 of heat treatment may not be performed. For example, in a case where underlying substrate 11 is a sapphire substrate, grown GaN crystal 17 is not much affected even though these steps S7 and S8 are not performed. On the other hand, for example, in a case where underlying substrate 11 is a GaAs substrate, good crystallinity of grown GaN crystal 17 can be achieved by performing these steps S7 and S8.

Fig. 11 is a schematic cross-sectional view showing a state where GaN crystal 17 was grown in the present embodiment. Then, as shown in Figs. 9 and 11, GaN crystal 17 is grown (step S5). In the present embodiment, GaN crystal 17 is grown on mask layer 13 and buffer layer 19. The present embodiment is otherwise the same as Embodiment 1Z. GaN crystal 17 can be grown through steps S1 to S5, S7, and S8 above.

Then, as shown in Fig. 9, underlying substrate 11 and mask layer 13 are removed (step S6). In the present embodiment, buffer layer 19 is further removed. The present embodiment is otherwise the same as Embodiment 1Z. GaN crystal 10 shown in Fig. 1 can be manufactured through steps S1 to S8 above.

Since the method of growing GaN crystal 17 and the method of manufacturing GaN crystal 10 are otherwise the same as in Embodiment 1Z, the same members have the same reference characters allotted and description thereof will not be repeated.

As described above, the method of growing GaN crystal 17 and the method of manufacturing GaN crystal 10 in the present embodiment further include step S7 of forming buffer layer 19 and step S8 of subjecting buffer layer 19 to heat treatment at a temperature not lower than 800°C and not higher than 1100°C between step S4 of cleaning with an organic solvent and step S5 of growing GaN crystal 17.

Thus, good matching of a lattice constant between underlying substrate 11 and grown GaN crystal 17 can be achieved. Further, by subjecting buffer layer 19 to heat treatment at the temperature above, crystal in buffer layer 19 can be changed from amorphous to monocrystalline. Therefore, crystallinity of GaN crystal 17 can be improved. Thus, GaN crystal 17 of which polycrystalline area has further been made smaller can be grown.

### (Embodiment 3Z)

### GaN crystal in the present embodiment is similar to GaN crystal 10 in Embodiment 1Z shown in Fig. 1

In succession, a method of manufacturing GaN crystal in the present embodiment will be described. The method of manufacturing GaN crystal in the present embodiment is basically similar in features to the method of manufacturing GaN crystal in Embodiment 2Z, however, it is different in that a buffer layer is formed also on a mask layer.

Specifically, as shown in Fig. 9, underlying substrate 11 is prepared as in Embodiments 1Z and 2Z (step S1). Then, mask layer 13 is formed as in Embodiments 1Z and 2Z (step S2). Then, cleaning with an acid solution (step S3) and cleaning with an organic solvent (step S4) are performed as in Embodiments 1Z and 2Z.

Fig. 12 is a schematic cross-sectional view showing a state where buffer layer 19 was formed in the present embodiment. Then, as shown in Figs. 9 and 12, buffer layer 19 composed of GaN is formed on underlying substrate 11 (step S7). In the present embodiment, buffer layer 19 is grown in opening portion 13a in mask layer 13 on underlying substrate 11 as well as on mask layer 13. Namely, buffer layer 19 is grown to cover the entire mask layer 13.

Then, buffer layer 19 is subjected to heat treatment as in Embodiment 2Z (step S8).

Fig. 13 is a schematic cross-sectional view showing a state where GaN crystal 17 was grown in the present embodiment. Then, as shown in Figs. 9 and 13, GaN crystal 17 is grown (step S5). In the present embodiment, GaN crystal 17 is grown on buffer layer 19. The present embodiment is otherwise the same as Embodiment 2Z. GaN crystal 17 can be grown through steps S1 to S5, S7, and S8 above.

Then, as shown in Fig. 9, underlying substrate 11 and mask layer 13 are removed (step S6). In the present embodiment, buffer layer 19 is further removed as in Embodiment 2Z. GaN crystal 10 shown in Fig. 1 can be manufactured through steps S1 to S8 above.

Since the method of growing GaN crystal 17 and the method of manufacturing GaN crystal 10 are otherwise the same as in Embodiment 1Z, the same members have the same reference characters allotted and description thereof will not be repeated.

As described above, according to the present embodiment, buffer layer 19 is formed to cover the entire mask layer 13. Therefore, generation of a polycrystalline nucleus on buffer layer 19 on mask layer 13 is less likely. Therefore, regarding GaN crystal 17 formed above this mask layer 13, generation of polycrystal is suppressed. In addition, since lattice matching with underlying substrate 11 can be relaxed owing to buffer layer 19, crystallinity can be improved. Therefore, GaN crystal 17 of which polycrystalline area has further been made smaller and crystallinity has further been improved can be grown.

### [Example Z]

In the present example, an effect of including the step of cleaning with an acid solution and the step of cleaning with an organic solvent was examined.

### (Present Inventive Example 1Z)

In Present Inventive Example 1Z, GaN crystal 17 was grown basically in accordance with Embodiment 1Z described above.

Specifically, initially, underlying substrate 11 having a diameter of 60 mm and composed of sapphire was prepared (step S1).

Then, mask layer 13 composed of SiO₂ was formed on underlying substrate 11 (step S2). Specifically, SiO₂ layer 12 was vapor-deposited on underlying substrate 11 with sputtering under the conditions shown in Table 3 below. Thereafter, resist 15 was formed on SiO₂ layer 12 and it was patterned with a reactive ion etching (RIE) method, to thereby form mask layer 13 having opening portion 13a.

In step S2 of forming this mask layer 13, surface roughness Rms and a radius of curvature were measured at the time of forming the SiO₂ layer. Surface roughness Rms at 5 points in total, that is, in a central portion of the SiO₂ layer and at 4 points at positions distant by 100 µm in an upward direction, in a downward direction, in a right direction, and in a left direction from this central portion, respectively, was measured in the field of view of 10-µm square. The radius of curvature was measured as shown in Fig. 6. Table 3 below shows the results.

Then, underlying substrate 11 and mask layer 13 were cleaned with an acid solution (step S3). Hydrofluoric acid at concentration of 25 % was employed as the acid solution and ultrasound was applied for 15 minutes at a room temperature.

Then, underlying substrate 11 and mask layer 13 were cleaned with an organic solvent (step S4). Acetone was employed as the organic solvent and ultrasound was applied for 15 minutes at a room temperature.

Then, GaN crystal 17 was grown on underlying substrate 11 and mask layer 13 with the HVPE method (step S5). Specifically, underlying substrate 11 having mask layer 13 formed was loaded into a growth furnace. Then, an ammonia (NH₃) gas, a hydrogen chloride (HCl) gas, and gallium (Ga) were prepared as source materials for GaN crystal 17, an oxygen gas was prepared as a doping gas, and hydrogen (H₂) having purity not lower than 99.999 % was prepared as a carrier gas. Then, the HCl gas and Ga were caused to react as follows: Ga + HCl → GaCl + 1/2H₂. Thus, a gallium chloride (GaCl) gas was generated. This GaCl gas and the NH₃ gas were fed together with the carrier gas and the doping gas such that they impinge on underlying substrate 11 exposed through opening portion 13a in mask layer 13 to cause reaction on that surface at 1000°C as follows: GaCl + NH₃ → GaN + HCl + H₂. It is noted that, during growth of this GaN crystal 17, a partial pressure of the HCl gas was set to 0.001 atm and a partial pressure of the NH₃ gas was set to 0.15 atm. GaN crystal 17 in Present Inventive Example 1Z was thus grown.

### (Present Inventive Examples 2Z to 5Z)

In Present Inventive Examples 2Z to 5Z, GaN crystal 17 was grown basically in accordance with Embodiment 2Z described above.

Specifically, initially, underlying substrate 11 having a diameter of 60 mm and composed of GaAs was prepared (step S1).

Then, mask layer 13 composed of SiO₂ was formed on underlying substrate 11 (step S2). This step S2 was the same as in Present Inventive Example 1Z, except for sputtering under the conditions shown in Table 3 below.

Then, underlying substrate 11 and mask layer 13 were cleaned with an acid solution as in Present Inventive Example 1Z (step S3).

Then, underlying substrate 11 and mask layer 13 were cleaned with an organic solvent as in Present Inventive Example 1Z (step S4).

Then, buffer layer 19 composed of GaN was formed on underlying substrate 11 with the HVPE method (step S7). Specifically, underlying substrate 11 having mask layer 13 formed was loaded into a growth furnace, and buffer layer 19 was formed under the conditions shown in Table 3 below.

Then, buffer layer 19 was subjected to heat treatment at 900°C in an atmosphere containing hydrogen and ammonia (step S8).

Then, GaN crystal 17 was grown on underlying substrate 11 and mask layer 13 with the HVPE method under the growth conditions in Table 3 below (step S5).

### (Comparative Example 1Z)

Initially, an underlying substrate composed of GaAs as in Present Inventive Examples 2Z to 5Z was prepared (step S1).

Then, a mask layer composed of SiO₂ was formed on the underlying substrate with sputtering under the conditions shown in Table 3 below.

Then, underlying substrate 11 and mask layer 13 were cleaned with an organic solvent as in Present Inventive Example 1Z (step S4).

Then, a buffer layer was formed under the conditions shown in Table 3 below. Then, this buffer layer was subjected to heat treatment under the conditions shown in Table 3 below.

Then, GaN crystal was grown on underlying substrate 11 and mask layer 13 with the HVPE method under the growth conditions in Table 3 below.

**Table 3**

| | | | Present Inventive Example 1Z | Present Inventive Example 2Z | Present Inventive Example 3Z | Present Inventive Example 4Z | Present Inventive Example 5Z | Comparative Example 1Z |
|---|---|---|---|---|---|---|---|---|
| Underlying Substrate | | | Sapphire Substrate | GaAs Substrate | GaAs Substrate | GaAs Substrate | GaAs Substrate | GaAs Substrate |
| Mask Layer | Condition | Reached Pressure (Pa) | 5x10⁻³ | 5x10⁻³ | 5x10⁻² | 5x10⁻³ | 5x10⁻³ | 5x10⁻² |
| | | Sputtering Pressure (Pa) | 0.1 | 0.1 | 0.1 | 0.07 | 0.07 | 0.05 |
| | | Temperature of Underlying Substrate (°C) | 200 | 400 | 200 | 200 | 200 | 400 |
| | | Sputtering Current (W) | 1000 | 1000 | 1000 | 1000 | 1000 | 1000 |
| | Film Thickness (mn) | | 120 | 230 | 100 | 90 | 120 | 190 |
| | Radius of Curvature (m) | | 50 | 8 | 50 | 5 | 50 | 0.5 |
| | Surface Roughness Rms (nm) | | 0.2 | 5 | 2 | 0.5 | 0.2 | 4 |
| Cleaning | Condition | Solvent | Ultrasonic Cleaning With Acid Solution and Organic Solvent | Ultrasonic Cleaning With Acid Solution and Organic Solvent | Ultrasonic Cleaning With Acid Solution and Organic Solvent | Ultrasonic Cleaning With Acid Solution and Organic Solvent | Ultrasonic Cleaning With Acid Solution and Organic Solvent | Ultrasonic Cleaning With Organic Solvent |
| | | Temperature | Room Temperature | Room Temperature | Room Temperature | Room Temperature | Room Temperature | Room Temperature |
| | | Time (min) | 15 | 15 | 15 | 15 | 15 | 15 |
| Buffer Layer | Growth Condition | HCl Partial Pressure (atm) | - | 0.001 | 0.001 | 0.001 | 0.001 | 0.001 |
| | | NH₃ Partial Pressure (atm) | - | 0.1 | 0.1 | 0.1 | 0.1 | 0.1 |
| | | Temperature (°C) | - | 500 | 500 | 500 | 500 | 500 |
| | Annealing Condition | Temperature (°C) | - | 900 | 900 | 900 | 900 | 900 |
| | | Gas Atmosphere | - | H₂+NH₃ | H₂+NH₃ | H₂+NH₃ | H₂+NH₃ | H₂+NH₃ |
| GaN Crystal | Growth Condition | HCl Partial Pressure (atm) | 0.02 | 0.02 | 0.02 | 0.02 | 0.02 | 0.02 |
| | | NH₃ Partial Pressure (atm) | 0.15 | 0.15 | 0.15 | 0.15 | 0.15 | 0.15 |
| | | Temperature (°C) | 1000 | 1000 | 1000 | 1000 | 1000 | 1000 |
| | Area Occupied by Polycrystal (%) | | 5 | 33 | 5 | 5 | 2 | 100 |
| | Radius of Curvature of Crystal (m) | | 4 | 0.5 | 35 | 4 | 50 | Measurement could not be conducted because of many cracks |

### (Measurement Method)

An area occupied by polycrystal and a radius of curvature of GaN crystal, of GaN crystal in each of Present Inventive Examples 1Z to 5Z and Comparative Example 1Z were measured. The area occupied by polycrystal was measured as follows. Specifically, an area having a size of 2 inches in the center was irradiated with a white LED and a portion high in reflectance was determined as polycrystal. Then, the whole area was photographed by a CCD camera. Then, the number of bits of the portion high in reflectance in the photographed image was counted and a ratio of the number of bits to the entire GaN crystal was calculated. Regarding the radius of curvature, radius R, with a curve along the surface of GaN crystal 17 being assumed as drawing an arc, was measured as in the method shown in Fig. 6.

### (Measurement Results)

As shown in Table 3, regarding GaN crystal in each of Present Inventive Examples 1Z to 5Z where GaN crystal was grown, with cleaning with an acid solution and an organic solvent after formation of a mask layer, an area occupied by polycrystal was very low, that is, not higher than 33 %.

On the other hand, in Comparative Example 1Z where cleaning with an acid solution was not performed, an area in grown GaN crystal occupied by polycrystal was 100 %. In addition, a large number of cracks were generated and hence a radius of curvature of GaN crystal could not be measured. This may be because a resist-derived reaction product or the like caused by the resist used in forming a mask layer remained on the underlying substrate and the mask layer and a polycrystalline nucleus was generated.

From the foregoing, according to the present example, it could be confirmed that growth of polycrystalline GaN crystal was suppressed by including the step of cleaning with an acid solution and the step of cleaning with an organic solvent.

Though the embodiments and the examples of the present invention have been described above, combination of features in each of embodiments and examples as appropriate is originally intended. In addition, it should be understood that the embodiments and the examples disclosed herein are illustrative and non-restrictive in every respect. The scope of the present invention is defined by the terms of the claims, rather than the embodiments above, and is intended to include any modifications within the scope and meaning equivalent to the terms of the claims.

### DESCRIPTION OF THE REFERENCE SIGNS

1 cleaning bath; 3 ultrasound generation member; 5 control unit; 7 cleaning liquid; 9 holder; 10 GaN crystal; 11 underlying substrate; 12 SiO₂ layer; 13 mask layer; 13a opening portion; 15 resist; 17 GaN crystal; and 19 buffer layer.

## Claims

1. A method of growing gallium nitride crystal (17), comprising the steps of:
preparing an underlying substrate (11);
forming on said underlying substrate (11), a mask layer (13) having an opening portion (13a) and composed of silicon dioxide; and
growing gallium nitride crystal (17) on said underlying substrate (11) and said mask layer (13), and
said mask layer (13) having surface roughness Rms not greater than 2 nm.

2. The method of growing gallium nitride crystal (17) according to claim 1, wherein
said mask layer (13) has surface roughness Rms not greater than 0.5 nm.

3. The method of growing gallium nitride crystal (17) according to claim 1, wherein
said mask layer (13) has a radius of curvature not smaller than 8 m.

4. The method of growing gallium nitride crystal (17) according to claim 3, wherein
said mask layer (13) has a radius of curvature not smaller than 50 m.

5. The method of growing gallium nitride crystal (17) according to claim 1, further comprising the steps of:
forming a buffer layer (19) composed of gallium nitride on said underlying substrate (11); and
subjecting said buffer layer (19) to heat treatment at a temperature not lower than 800°C and not higher than 1100°C, between said step of forming a mask layer (13) and said step of growing gallium nitride crystal (17).

6. The method of growing gallium nitride crystal (17) according to claim 5, further comprising the steps of:
cleaning said underlying substrate (11) and said mask layer (13) with an acid solution; and
cleaning said underlying substrate (11) and said mask layer (13) with an organic solvent after said step of cleaning with an acid solution, between said step of forming a mask layer (13) and said step of forming a buffer layer (19).

7. The method of growing gallium nitride crystal (17) according to claim 1, further comprising the steps of:
cleaning said underlying substrate (11) and said mask layer (13) with an acid solution; and
cleaning said underlying substrate (11) and said mask layer (13) with an organic solvent after said step of cleaning with an acid solution, between said step of forming a mask layer (13) and said step of growing gallium nitride crystal (17).

8. The method of growing gallium nitride crystal (17) according to claim 7, wherein
in said step of cleaning with an acid solution and said step of cleaning with an organic solvent, ultrasound is applied to said acid solution and said organic solvent.

9. A method of manufacturing gallium nitride crystal (10), comprising the steps of:
growing gallium nitride crystal (17) with the method of growing gallium nitride crystal (17) according to claim 1; and
removing said underlying substrate (11) and said mask layer (13).

10. A method of growing gallium nitride crystal (17), comprising the steps of:
preparing an underlying substrate (11);
forming on said underlying substrate (11), a mask layer (13) having an opening portion (13a) and composed of silicon dioxide; and
growing gallium nitride crystal (17) on said underlying substrate (11) and said mask layer (13), and
said mask layer (13) having a radius of curvature not smaller than 8 m.

11. The method of growing gallium nitride crystal (17) according to claim 10, wherein
said mask layer (13) has a radius of curvature not smaller than 50 m.

12. The method of growing gallium nitride crystal (17) according to claim 10, further comprising the steps of:
forming a buffer layer (19) composed of gallium nitride on said underlying substrate (11); and
subjecting said buffer layer (19) to heat treatment at a temperature not lower than 800°C and not higher than 1100°C, between said step of forming a mask layer (13) and said step of growing gallium nitride crystal (17).

13. The method of growing gallium nitride crystal (17) according to claim 12, further comprising the steps of:
cleaning said underlying substrate (11) and said mask layer (13) with an acid solution; and
cleaning said underlying substrate (11) and said mask layer (13) with an organic solvent after said step of cleaning with an acid solution, between said step of forming a mask layer (13) and said step of subjecting a buffer layer (19) to heat treatment.

14. The method of growing gallium nitride crystal (17) according to claim 10, further comprising the steps of:
cleaning said underlying substrate (11) and said mask layer (13) with an acid solution; and
cleaning said underlying substrate (11) and said mask layer (13) with an organic solvent after said step of cleaning with an acid solution, between said step of forming a mask layer (13) and said step of growing gallium nitride crystal (17).

15. The method of growing gallium nitride crystal (17) according to claim 14, wherein
in said step of cleaning with an acid solution and said step of cleaning with an organic solvent, ultrasound is applied to said acid solution and said organic solvent.

16. A method of manufacturing gallium nitride crystal (10), comprising the steps of:
growing gallium nitride crystal (17) with the method of growing gallium nitride crystal (17) according to claim 10; and
removing said underlying substrate (11) and said mask layer (13).

17. A method of growing gallium nitride crystal (17), comprising the steps of:
preparing an underlying substrate (11);
forming a mask layer (13) having an opening portion (13a) on said underlying substrate (11) by using a resist (15);
cleaning said underlying substrate (11) and said mask layer (13) with an acid solution;
cleaning said underlying substrate (11) and said mask layer (13) with an organic solvent after said step of cleaning with an acid solution; and
growing gallium nitride crystal (17) on said underlying substrate (11) and said mask layer (13).

18. The method of growing gallium nitride crystal (17) according to claim 17, wherein
in said step of cleaning with an acid solution and said step of cleaning with an organic solvent, ultrasound is applied to said acid solution and said organic solvent.

19. The method of growing gallium nitride crystal (17) according to claim 17, wherein
said mask layer (13) is composed of silicon dioxide.

20. The method of growing gallium nitride crystal (17) according to claim 17, further comprising the steps of:
forming a buffer layer (19) composed of gallium nitride on said underlying substrate (11); and
subjecting said buffer layer (19) to heat treatment at a temperature not lower than 800°C and not higher than 1100°C, between said step of cleaning with an organic solvent and said step of growing gallium nitride crystal (17).

21. A method of manufacturing gallium nitride crystal (10), comprising the steps of:
growing gallium nitride crystal (17) with the method of growing gallium nitride crystal (17) according to claim 17; and
removing said underlying substrate (11) and said mask layer (13).
